# NEUE EUROPÄISCHE PATENTSCHRIFT

(11) **EP 2 886 021 B2**
(45) Veröffentlichungstag und Bekanntmachung des Hinweises auf die Entscheidung über den Einspruch: **16.08.2023**
(45) Hinweis auf die Patenterteilung: 08.03.2017
(21) Anmeldenummer: 14169527.0
(22) Anmeldetag: 22.05.2014
(51) Int. Cl.: A47F 11/10, A47F 5/10, H01R 25/14

(54) **Regalsystem mit elektrischer Versorgung**
Shelving system with electricity supply
Système d'étagère dotée d'une alimentation électrique

(30) Priorität: 18.12.2013 DE 102013114289
(43) Veröffentlichungstag der Anmeldung: 24.06.2015
(73) Patentinhaber: JUVEMA AG, 8268 Salenstein (CH)
(72) Erfinder: Kraiss, Hans, 72574 Bad Urach (DE)
(74) Vertreter: Rüger Abel Patentanwälte PartGmbB

(56) Entgegenhaltungen:
- EP-A1- 0 007 071
- EP-A2- 0 974 292
- WO-A1-2006/067396
- WO-A1-2012/009822
- WO-A1-2013/087081
- WO-A1-2013/087081
- WO-A2-2005/099522
- WO-A2-2005/099522
- CH-A5- 601 930
- DE-A1-102007 028 395
- DE-U1-202008 001 773
- DE-U1-202012 008 355
- DE-U1-202012 008 355
- FR-A1- 2 803 995
- US-A- 3 733 755
- US-A- 4 973 796
- US-A- 5 690 415
- US-A1- 2002 085 373
- US-A1- 2006 209 537
- US-A1- 2008 043 456

## Beschreibung

Die vorliegende Erfindung betrifft ein Regalsystem mit wenigstens einer im Einsatz senkrechten Regalschiene und wenigstens einer an der Regalschiene höhenverstellbar fixierbaren Konsole für ein Trägerelement, insbesondere ein Fachbodenelement, wobei die Konsole oder das Trägerelement ein elektrisches Gerät, insbesondere eine Beleuchtungseinrichtung tragen kann, das über das Regalsystem mit elektrischer Energie versorgt wird.

Derartige Regalsysteme können bspw. für den Ladenbau zur Warenpräsentation verwendet werden und sind in vielfältigen Ausführungsformen bekannt. Häufig werden Kragarmregale verwendet, bei denen als Winkelkonsolen ausgeführte Regalhalterungen zum Tragen von Fachböden oder sonstigen Trägerelementen freikragend in Regalschienen eingehängt werden, die als Wandschienen oder aufstellbare Regalsäulen bzw. Regalpfosten ausgebildet sind und periodische Lochungen zur Aufnahme der Regalkonsolen in unterschiedlicher Höhe aufweisen. Die Lochungen können einfach vertikal gleichmäßig voneinander beabstandete Schlitze sein. Die Regalkonsolen greifen mit im Allgemeinen hakenförmigen Eingriffsabschnitten hinter die Vorderfläche der Regalschienen in die Schlitze ein und sichern so die Regalkonsolen in der gewünschten Position. Die Fachbodenelemente werden entweder oben auf die Regalkonsolen oder auf rechtwinklig an diesen angeformten Auflageabschnitten befestigt.

Derartige Regalsysteme ermöglichen eine leichte Montage, Zerlegung und Anpassung des Regals an die jeweiligen Bedürfnisse. Die Fachbodenelemente und dgl. können schnell und einfach in jeder gewünschten Höhe eingehängt werden.

Es ist ferner bekannt, an den Fachböden oder sonstigen Trägerelementen von Regalen elektrische Geräte, insbesondere Beleuchtungseinrichtungen, wie z.B. Halogen- oder LED-Leuchten, vorzusehen, um durch Beleuchtung einer Ware mit Licht unterschiedliche optische Effekte zu erzielen. Eine Beleuchtungseinrichtung kann bspw. an der vorderen oder einer seitlichen unteren Kante eines Fachbodens montiert sein, um das darunterliegende Fach zu beleuchten. Zur Energieversorgung müssen Verbindungskabel von der Beleuchtungseinrichtung zu einem elektrischen Stromversorgungsanschluss, z.B. einer Steckdose, geführt werden. Bei Regalsystemen für den Ladenbau, ist eine dezente, unauffällige Führung der Verbindungskabel erwünscht.

Aus der Praxis sind Regalsysteme insbesondere für die Wandmontage bekannt, bei denen in die vertikalen Stützen stromführende Schienen integriert sind. Meist ist in jeder Stütze nur ein einziger Innenleiter, entweder für Pluspol oder für Minuspol bei Gleichstromversorgung, untergebracht, so dass die Fachböden zu ihren beiden Seiten mit den beiden Polen in verschiedenen Stützen zu verbinden sind.

Ein derartiges Regalsystem ist z.B. aus der WO 2005/099522 A2 bekannt. In diesem Regalsystem ist in jeder Regalschiene ein Einsatz mit einer C-förmigen, elektrisch leitfähigen Stromschiene eingesetzt, die mit einem einzelnen Anschluss einer Wechselstromversorgung verbunden ist. Auf jeder Winkelkonsole ist ein streifenförmiger Leiter aufgeklebt, der sich von einem hakenförmigen Eingriffsende der Konsole bis zu deren entgegengesetztem Ende erstreckt, um eine Verbindung zwischen der Stromschiene und einem Anschluss der Beleuchtungseinrichtung zu schaffen. Ein Stromkreis führt somit über zwei Stromschienen in gesonderten Regalschienen und über zwei Konsolen, die jeweils mit dem aufgeklebten Leiterstreifen versehen sind und einen Fachboden tragen. Dies ist hinsichtlich des Verdrahtungsaufwands aufwändig und kostenintensiv. Außerdem liegen die auf die Konsolen aufgeklebten Leiterstreifen frei und können leicht von außen berührt werden, was bei Ladeneinrichtungen eine inakzeptable Gefahr für Personal und Kunden darstellt.

Es sind auch Regalsysteme bekannt, bei denen beide Leiter eines Stromkreises in einer einzigen Regalschiene integriert sind und für den Anschluss einer Beleuchtungseinrichtung an ein oder mehreren Stellen der Regalschiene Anschlüsse nach Art von Steckdosen vorgesehen sind, in die Stecker oder sonstige Verbinder der Beleuchtungseinrichtung eingesteckt werden können. Nachteilig hierbei ist jedoch, dass die Anschlüsse nur an diskreten Stellen einer Regalschiene vorgesehen sein können, was sowohl die Verstellbarkeit der Fachböden in ihrer Höhe beschränkt als auch durch die sichtbaren Verbindungskabel und Stecker die Ästhetik beeinträchtigen kann. Außerdem wäre eine einfachere Handhabung erwünscht.

WO 2013/087081 A1 offenbart ein System zur Elektrifizierung zumindest eines elektrischen Verbrauchers an einem Möbel mit einem Gehäuse, das nach Art einer senkrechten geschlitzten Regalschiene ausgebildet ist, mit einem in dem Gehäuse untergebrachten Stromprofil, das zwei Stromschienen aufweist, die parallel zueinander, senkrecht in dem Stromprofil angeordnet sind, und mit einem Träger, der nach Art einer Einhängekonsole ausgeführt ist und ein Möbelelement tragen kann. An dem Träger ist eine Tragfolie aus elektrisch isolierendem Material aufgeklebt, die elektrische Leiterbahnen trägt, die jeweils aus einer elektrisch leitfähigen Schicht gebildet sind. Den Leiterbahnen sind elektrisch leitfähige Kontaktflächen zugeordnet, die jeweils an einer Eingriffslasche starr angebracht sind und dazu dienen, mit den Stromschienen in dem Gehäuse in Kontakt zu gelangen, wenn die Eingriffslaschen durch jeweilige Gehäuseschlitze hindurch in das Gehäuse eingehängt werden.

Aus der DE 34 39 657 A1 ist ein mit einer Beleuchtungseinrichtung versehenes Regal bekannt, bei dem die Stromzuführungsleitungen verdeckt in dem Hohlraum der Regalschienen verlegt sind, während die Konsolen für die Regalböden mit der Beleuchtungseinrichtung zu einer baulichen Einheit vereinigt sind und Kontaktelemente aufweisen, die beim Einhängen in die Regalschiene die stromleitende Verbindung mit den Stromzuführungsleitungen herstellen. In einer Ausführungsform sind in der Regalschiene zwei mit Kontaktfedern versehende Stromschienen vorgesehen, die versetzt zueinander auf einer Isolierplatte angeordnet sind, die in dem Innenraum an der Rückwand der Regalschiene befestigt ist. Die Kontaktelemente für den Stromabgriff sind an Stirnflächen der zum Einhängen in die Regalschiene dienenden hakenförmigen Ansätze der Konsole angeordnet. Die von den Kontaktelementen zu der Beleuchtungseinrichtung führenden Verbindungsleitungen sind innerhalb der Konsole verlegt. Dies erfordert speziell konstruierte Konsolen mit kompliziertem und sperrigem Aufbau.

Es wäre wünschenswert, herkömmliche Winkelkonsolen aus plattenförmigem Material, insbesondere aus Stahlblech oder dgl., nutzen zu können, die in Verbindung mit einfachen Schlitzschienen verwendet werden können. Außerdem wäre es wünschenswert, wenn die Regalschienen sowohl für die Wandmontage oder auch für Regalständer mit sowohl an der Vorder- als auch an der Rückseite einhängbaren Fachbodenelementen flexibel verwendbar wären, und dies möglichst ohne streng auf die Aufbaulage der Regalschienen achten zu müssen.

DE 20 1012 008 355 U1 offenbart ein Regalsystem mit einer im Einsatz senkrechten Regalschiene, die eine mäanderförmige Gestalt mit einer Rückenstrebe aufweist, von der u.a. zwei Flankenstreben und ein Mittelsteg vorragen, wobei zwischen jeder Flankenstrebe und dem Mittelsteg eine innere Passage definiert ist, die zur Rückseite hin durch die Rückenstrebe begrenzt ist und zur Vorderseite hin offen ist. In der Rückenstrebe sind zwei parallele Schlitzraster jeweils zwischen einer Flankenstrebe und dem Mittelsteg angeordnet. Ferner ist in jeder inneren Passage zwischen einer Flankenstrebe und dem Mittelsteg eine Stromschiene zur Energieversorgung integriert, die einen ersten und einen zweiten Stromleiter aufweist, die entlang des Mittelstegs im Abstand nebeneinander verlaufen und voneinander isoliert sind. Außerdem weist das Regalsystem wenigstens eine Konsole für ein Trägerelement, z.B. ein Fachbodenelement, auf, die zum lösbaren Einhängen in einen der Schlitze der Regalschiene eingerichtet ist. Die Konsole weist wenigstens einen bspw. hakenförmigen Eingriffsabschnitt, der eingerichtet und angeordnet ist, um von außen durch die innere Passage zwischen einer Flankenstrebe und dem Mittelsteg hindurch geführt und in einen Schlitz eingehängt zu werden, einen Trägerabschnitt für ein Trägerelement, der im eingehängten Zustand der Konsole an der Vorderseite aus der Regalschiene herausragt, und einen Zwischenabschnitt zwischen dem Eingriffsabschnitt und dem Trägerabschnitt auf, der sich im eingehängten Zustand der Konsole in der inneren Passage befindet. An der Konsole ist eine Stromabnehmereinrichtung befestigt, die ein Gehäuse mit einem Stromabnahmeabschnitt und einem mit dem Stromabnahmeabschnitt verbundenen Verbindungsabschnitt aufweist. Der Stromabnahmeabschnitt ist an dem Zwischenabschnitt der Konsole angeordnet und weist aus dem Gehäuse herausragende Abgriffkontakte zur Kontaktierung der Stromleiter der Stromschiene auf. Der Verbindungsabschnitt ist an dem Trägerabschnitt der Konsole angeordnet und zur stromleitenden Verbindung der Abgriffkontakte mit einem Anschlusskabel eines elektrischen Gerätes vorgesehen. Die Abgriffkontakte sind federnd eingerichtet und angeordnet, um beim Einschieben in die innere Passage zurückgedrückt zu werden und bei kongruenter Positionierung zu den Stromleitern durch die Federkraft an die Stromleiter angedrückt zu werden, um eine elektrisch leitende Verbindung mit diesen herzustellen.

Es ist eine Aufgabe der Erfindung, ein Regalsystem mit wenigstens einer Regalschiene und wenigstens einer in die Regalschiene einhängbaren Konsole für ein Trägerelement, insbesondere ein Fachbodenelement, und mit einer elektrischen Anbindung für eine Beleuchtungseinrichtung oder ein sonstiges elektrisches Gerät zu schaffen, das relativ einfach konstruiert und zum Auf-, Ab- und Umbau einfach handhabbar ist und die funktionalen und ästhetischen Anforderungen insbesondere des Ladenbaus erfüllt. Insbesondere sollte ein derartiges Regalsystem es ermöglichen, die Trägerelemente in ihrer Höhe leicht und schnell individuell zu verstellen und die Anschlussverbindung für die Beleuchtungseinrichtung oder dgl. unaufwändig und schnell vorzunehmen.

Diese Aufgabe wird erfindungsgemäß durch ein Regalsystem mit den Merkmalen des Patentanspruches 1 gelöst. Besonders vorteilhafte Ausführungsformen sind Gegenstand der Unteransprüche.

Das erfindungsgemäße Regalsystem weist wenigstens eine Regalschiene auf, die im Einsatz mit ihrer Längserstreckung senkrecht auszurichten ist und wenigstens eine Vorderwand und zwei Seitenwände aufweist, die einen Innenraum der Regalschiene begrenzen. In der Vorderwand der Regalschiene sind eine oder mehrere Reihen von Lochungen zur Montage von Trägerelementen in unterschiedlicher Höhe vorgesehen, wobei die Lochungen längst der Regalschiene im Abstand zueinander angeordnet sind und einen Zugang zu dem Innenraum schaffen. In dem Innenraum der Regalschiene ist eine Stromschiene zur Energieversorgung integriert, die wenigstens abschnittsweise entlang der Regalschiene verläuft und einen ersten und einen zweiten Stromleiter aufweist, die entlang einer der Seitenwände der Regalschiene im Abstand nebeneinander verlaufen und voneinander isoliert sind. Ferner weist das Regalsystem wenigstens eine Konsole für ein Trägerelement, z.B. ein Fachbodenelement, auf, die zum lösbaren Einhängen in eine der Lochungen der Regalschiene eingerichtet ist. Die Konsole weist wenigstens einen Eingriffsabschnitt, der eingerichtet und angeordnet ist, um zum Einhängen der Konsole von außen durch eine der Lochungen in der Vorderwand hindurch in den Innenraum der Regalschiene eingeführt zu werden, um im eingehängten Zustand in dem Innenraum angeordnet zu sein, und einen mit dem Eingriffsabschnitt verbundenen Trägerabschnitt für ein Trägerelement auf, der im eingehängten Zustand der Konsole aus der Regalschiene herausragt. An der Konsole ist eine Stromabnehmereinrichtung befestigt, die ein Gehäuse mit einem Stromabnahmeabschnitt und einem mit dem Stromabnahmeabschnitt verbundenen Verbindungsabschnitt aufweist. Der Stromabnahmeabschnitt ist an dem Eingriffsabschnitt der Konsole angeordnet und weist aus dem Gehäuse herausragende Abgriffkontakte zur Kontaktierung der Stromleiter der Stromschiene auf. Der Verbindungsabschnitt ist an dem Trägerabschnitt der Konsole angeordnet und zur stromleitenden Verbindung der Abgriffkontakte mit einem Anschlusskabel eines elektrischen Gerätes vorgesehen. Die Abgriffkontakte sind federnd eingerichtet und angeordnet, um beim Einhängen der Konsole in die Regalschiene gegen die Federkraft in das Gehäuse eingedrückt zu werden und nach Passieren der jeweiligen Lochung in dem Innenraum der Regalschiene hinter der Vorderwand durch die Federkraft aus dem Gehäuse heraus und an den ersten bzw. zweiten Stromleiter der Stromschiene angedrückt zu werden, um eine elektrisch leitende Verbindung mit diesen herzustellen.

Das erfindungsgemäße Regalsystem ist insbesondere zur Warenpräsentation für den Ladenbau bestimmt. Es ist äußerst einfach konstruiert und ermöglicht eine einfache Handhabung beim Auf-, Ab- und Umbau. Die Konsolen werden einfach in der jeweils gewünschten Höhe in die entsprechende Lochung eingehängt, wobei automatisch, also selbsttätig, ohne irgendwelche zusätzlichen Aktionen des Bedieners zu erfordern, eine Kontaktierung der Innenleiter in der Regalschiene durch die Abgriffkontakte der erfindungsgemäßen Konsole erzielt wird. Ein Trägerelement, z.B. ein Fachbodenelement mit der an diesem vorgesehenen Beleuchtungseinrichtung oder einem sonstigen elektrischen Gerät, kann z.B. anschließend oder bereits vorher auf der Konsole montiert werden, wobei das Anschlusskabel der Beleuchtungseinrichtung oder dgl. einfach in dem Verbindungsabschnitt angeschlossen wird. Das Regalsystem kann durch einfaches Aushängen der Konsole bzw. Konsolen eines jeweiligen Fachbodenelements aus der oder den zugehörigen Lochungen und Einhängen in andere Lochungen leicht und schnell umgebaut werden. Gleichzeitig wird automatisch der Stromkreis für die Beleuchtungseinrichtung oder dgl. geschlossen. Vorteilhafterweise sind die Stromzuführungsleitungen für die Beleuchtungseinrichtung oder dgl. in einer einzigen Stromschiene und einer einzigen Konsole angeordnet, was im Vergleich zu einer auf unterschiedliche Regalschienen und Konsolen verteilten Leitungsanordnung eine konstruktiv einfachere und kostengünstigere Gestaltung darstellt und eine einfachere Anschlussherstellung ermöglicht. Die Leitungslängen und der Verdrahtungsaufwand können deutlich reduziert werden. Die Stromabnehmer an der Konsole können in dem Gehäuse nach außen im Wesentlichen unsichtbar und von außen unberührbar geführt werden.

Das erfindungsgemäße Regalsystem kann als ein Wandregal mit einer zur Montage an einer vertikalen Wand eingerichteten Wandschiene ausgebildet sein. Die Wandschiene kann zur direkten Montage, z.B. durch Anschrauben, an der Wand oder zum Aufhängen an einer bspw. horizontalen Leiste oder dgl. eingerichtet sein.

Die Regalschiene kann auch Teil eines zum Aufstellen auf einen Boden eines Raums eingerichteten Regalgestells bilden. Die Regalschiene kann ein Standrohr zum Aufstellen auf dem Boden selbst sein oder eine mit einem Standfuß verbundene Regalsäule oder -stütze des Regalgestells bilden.

Wenngleich die Erfindung auf ein Regalgestell mit lediglich einer einzigen Regalschiene bzw. -säule anwendbar ist, wird das erfindungsgemäße Regalsystem im Allgemeinen wenigstens zwei Regalschienen aufweisen, die in vertikaler Ausrichtung parallel und nebeneinander angeordnet sind. Ein Fachbodenelement oder ein sonstiges Trägerelement ist dann über jeweilige Konsolen an zwei oder mehreren Regalschienen gehaltert, wobei die Stromversorgung für eine Beleuchtungseinrichtung oder dgl. über lediglich eine einzelne Regalschiene mit integrierter Stromschiene und eine einzelne Konsole mit integrierter Stromabnehmereinrichtung erfolgt.

Die Regalschiene kann durch eine beliebige Profilschiene gebildet sein, die einen hohlen Innenraum und an wenigstens einer Wand oder einem Wandabschnitt eine oder mehrere Reihen von Lochungen zum Einhängen der Konsolen aufweist. Sie kann im Querschnitt rund, U- oder C-profilförmig gestaltet sein. In einer bevorzugten Ausführungsform der Erfindung ist die Regalschiene ein Rechteckrohr oder -profil, das vorzugsweise aus einem metallischen Werkstoff, insbesondere Stahl, gefertigt ist. Die Regalschiene weist dann ferner eine Rückwand auf, die parallel und im Abstand zu der Vorderwand zwischen den Seitenwänden verläuft und eine oder mehrere Reihen von Lochungen ähnlich oder identisch wie die Lochungen an der Vorderwand aufweist. Somit können auch in der Rückwand Konsolen mit Trägerelementen angeordnet werden.

Wenn die Regalschiene, einschließlich der darin integrierten Stromschiene, symmetrisch bezüglich einer senkrecht durch die Vorderwand und die Rückwand verlaufenden Mittelebene sowie symmetrisch bezüglich einer senkrecht durch die Seitenwände verlaufenden Mittelebene ausgebildet ist, dann braucht beim Auf- und Umbau des Regalsystems kaum auf die Ausrichtung der Regalschiene geachtet zu werden. Die Vorderwand entspricht der Rückwand. Es lassen sich unterschiedliche Regalgestelle mit zur Vorder- und Rückseite freitragenden Fachbodenelementen mühelos errichten.

In einer bevorzugten Ausführungsform sind die Lochungen in Form von vorzugsweise äquidistanten Schlitzen ausgebildet, die durch die jeweilige Vorderwand und gegebenenfalls die Rückwand der Regalschiene hindurchführen und in deren Längsrichtung ausgerichtet sind. Derartige Regalschienen mit ein- oder zweireihigen vertikalen Einhängeschlitzen sind besonders einfach und kostengünstig herstellbar.

Die Weite der Einhängeschlitze ist vorzugsweise derart gewählt, dass ein Eingreifen wenigstens einer Hand eines Erwachsenen, vorzugsweise auch einer Kinderhand, in den Einhängeschlitz nahezu unmöglich ist, um ein Berühren der Stromleiter in der Regalschiene wirksam zu verhindern. Z.B. kann die Schlitzweite maximal 4-5 mm betragen. Die Höhe des Schlitzes kann beliebig sein und kann bspw. 15 mm, 20 mm oder sogar mehr betragen. Je nach gewünschter Verstellbarkeit können die Schlitze im Abstand von bspw. 30 mm, 40 mm, 50 mm oder dgl. zueinander vorgesehen sein, wobei auch kleinere oder größere Intervalle sowie nicht äquidistante Schlitzraster möglich sind.

Die in der Regalschiene integrierte Stromschiene ist vorzugsweise zur Niedervolt-Energieversorgung vorgesehen. Unter Niedervolt werden in diesem Zusammenhang insbesondere Spannungen verstanden, die die Grenzwerte für Wechselspannung von 50 Volt und für Gleichspannung von 120 Volt nicht überschreiten. Im letzteren Fall sind die Spannungen vorzugsweise ebenfalls kleiner als etwa 50 Volt. Bevorzugter Weise handelt es sich um übliche 6 Volt-, 12 Volt- oder 24 Volt-Spannungen herkömmlicher Halogen- oder LED-Systeme. Insofern bilden Halogen- oder LED-Leuchten bevorzugte Beleuchtungseinrichtungen oder elektrische Geräte, die an Konsolen bzw. Fachbodenelementen des erfindungsgemäßen Regalsystems befestigt werden.

In einer besonders bevorzugten Ausführungsform ist die Stromschiene zur Niedervolt-Energieversorgung für Gleichstrom eingerichtet und weist wenigstens einen ersten Stromleiter für einen ersten Pol, z.B. einen Plusleiter, und einen zweiten Stromleiter für einen zweiten, unterschiedlichen Pol, z.B. einen Minusleiter, auf.

Sofern erwünscht, könnte die Stromschiene für die Wechselstromanwendung wenigstens einen Phasenleiter und einen Neutralleiter aufweisen und gegebenenfalls zusätzlich einen Schutzleiter mitführen. Prinzipiell könnten die Stromleiter in der Stromschiene der Regalschiene auch nur oder zusätzlich zur Datenübertragung dienen.

In einer Ausführungsform weist die Stromschiene einen Grundkörper aus einem elektrisch isolierenden Material auf, der wenigstens eine wenigstens einer Seitenwand der Regalschiene zugeordnete Leiste aufweist, in der der erste und der zweite Stromleiter der Stromschiene vorzugsweise in Form von Leiterstreifen parallel und im Abstand zueinander derart eingebettet sind, dass sie von dem isolierenden Material getrennt und umgriffen sind. Die Stromleiter sind dann gegenüber dem am weitesten in den Innenraum der Regalschiene hinein reichenden Isolationsmaterial zurückversetzt angeordnet. Dadurch können Kurzschlüsse weitgehend vermieden und der Berührungsschutz gegen eine Berührung von außen erhöht werden.

Gemäß der Erfindung sind die zu einem Stromkreis (bzw. zu einer Datenübertragungsverbindung) gehörenden Stromleiter an der wenigstens einen Leiste der Stromschiene entlang einer einzigen Seitenwand der Regalschiene angeordnet, was bedeutet, dass die Stromleiter längs der Erstreckung der zugeordneten Seitenwand parallel und im Abstand zu dieser und zueinander verlaufen. Dabei können die Stromleiter von der zugeordneten Seitenwand nur geringfügig beabstandet, bspw. nur durch die Dicke des isolierenden Materials getrennt sein, oder sie können sich auch in größerem Abstand zu der zugeordneten Seitenwand der Regalschiene, bspw. auch in etwa in der Mitte zwischen dieser und der gegenüberliegenden Seitenwand oder sogar näher zu der letzteren befinden. Jedenfalls sind die Stromleiter zu der Seite der gegenüberliegenden Seitenwand hin freigelegt und von dieser Seite aus für einen Stromabgriff zugänglich. Die Abgriffkontakte für den Stromabgriff sind an dem Eingriffsabschnitt der Konsole seitlich herausgeführt. Durch eine geeignete elastisch federnde Gestaltung der Abgriffkontakte wird sichergestellt, dass diese die Stromleiter mit hoher Kontaktsicherheit berühren.

In einer Ausführungsform der Erfindung ist der Grundkörper der Stromschiene durch ein H-Profil gebildet, dessen Breite und Tiefe an die Breite und Tiefe des Innenraums der Regalschiene angepasst sind, so dass die Stromschiene in der Regalschiene vorzugsweise durch Kraftschluss relativ unbeweglich festgehalten ist. Das H-Profil weist zwei zueinander parallele Leisten und einen die Leisten verbindenden Mittelsteg auf. An einer der Leisten ist wenigstens ein erstes Paar aus einem ersten und zweiten Stromleiter angeordnet, und wenigstens ein zweites Paar aus einem ersten und zweiten Stromleiter ist an der anderen Leiste derart angeordnet, dass eine in jeder Querschnittsebene in Bezug auf einen Mittelpunkt des Mittelstegs spiegel- und/oder punktsymmetrische Anordnung geschaffen ist. Eine derartige Regalschiene ist flexibel und einfach verwendbar.

In einer modifizierten Ausführungsform weist der Grundkörper der Stromschiene einen im Wesentlichen rechteckrohrprofilartigen Mittelkörper, der der Befestigung in der Regalschiene dient, und wenigstens eine von einer Seite des Mittelkörpers aus vorragende Leiste auf, die die zwei oder mehreren zu einem Stromkreis gehörenden Stromleiter trägt. Der Mittelkörper weist vorzugsweise eine Breite, die an die Breite des Innenraums der Regalschiene angepasst ist, aber eine deutlich geringere Tiefe als der Innenraum auf. Damit ist einerseits ein relativ leichtes Einführen der Stromschiene in die Regalschiene in Längsrichtung derselben zur Montage möglich, während andererseits eine hinreichende Kraftschlussverbindung mit dieser im Einsatz aufrechterhalten werden kann. Wie bei dem H-Profil können durch geeignete Vorsprünge an dem Grundkörper lediglich schmalflächige oder linienartige Kontaktbereiche zwischen diesem und der Regalschiene vorgesehen sein, die die Handhabung erleichtern. Die Leiste mit den Stromleitern kann bspw. in etwa in der Mitte der der Vorderwand zugeordneten Seite des Mittelkörpers angeordnet sein und sich nach außen, im montierten Zustand in Richtung auf die Vorderwand erstrecken. Die Stromleiter sind zumindest auf einer zu der Vorderwand senkrecht ausgerichteten Fläche der Leiste angeordnet. Es können aber auch auf beiden Flächen der Leiste, die den Seitenwänden der Regalschiene gegenüberliegen, Stromleiter für unterschiedliche Stromkreise bzw. Datenübertragungsverbindungen angeordnet sein. Vorzugsweise ist eine weitere entsprechende Leiste mit Stromleitern an der gegenüberliegenden Seite des Mittelkörpers, bevorzugter Weise ebenfalls mittig, ausgebildet und von der Rückwand bzw. Rückseite der Regalschiene aus zugänglich.

Die erfindungsgemäße Konsole ist vorzugsweise als eine Winkelkonsole aus einem flachen, plattenartigen Material, vorzugsweise aus Stahlblech, gefertigt. Es sind andere, auch nicht-metallische Materialien möglich. Die Konsole weist vorzugsweise einen flachen Trägerabschnitt, der sich im Einsatz mit einer Stützkante an der Vorderwand (oder Rückwand, je nach Anordnung) der Regalschiene abstützen kann, sowie wenigstens einen hakenförmigen Eingriffsabschnitt auf, der an der Stützkante vorragt und eingerichtet ist, um eine die zugehörige Lochung begrenzende Wand sattelartig zu umgreifen. Derartige Konsolen sind einfach gestaltet und weit verbreitet. Sie lassen sich kostengünstig fertigen.

Der Stromabnahmeabschnitt der Stromabnehmereinrichtung kann an dem hakenförmigen Eingriffsabschnitt angeordnet sein. Die Konsole kann dann auch nur einen einzigen Eingriffsabschnitt in Form eines Einhängehakens aufweisen.

In einer bevorzugten Ausführungsform weist die Konsole den ersten, hakenförmigen Eingriffsabschnitt und einen weiteren Eingriffsabschnitt auf, der im Abstand zu dem ersten Eingriffsabschnitt von der Stützkante vorragt und den Stromabnahmeabschnitt der Stromabnehmereinrichtung umfasst. Der weitere Eingriffsabschnitt mit den Abgriffkontakten der Stromabnehmereinrichtung kann, muss aber nicht als ein Einhängehaken ausgebildet sein. Jedenfalls greift er auch in eine Lochung ein, um eine zusätzliche Sicherung an der Regalschiene zu ermöglichen. Mit zwei Eingriffsabschnitten wird eine stabilere Anordnung und Halterung der Konsole an der Regalschiene erzielt.

Der Abstand der Eingriffsabschnitte kann dem Abstand der Lochungen an der Regalschiene entsprechen oder auch ein Vielfaches davon betragen.

In einer besonders stabilen und gut handhabbaren Ausführungsform ist der obere Eingriffsabschnitt der Konsole als ein Einhängehaken ausgebildet, während der untere, im Wesentlichen rechteckige Eingriffsabschnitt die Abgriffkontakte trägt.

Zur Montage von Trägerelementen, insbesondere Fachbodenelementen, kann die Konsole einen senkrecht zu dem Trägerabschnitt ausgerichteten Auflageabschnitt aufweisen. Der Auflageabschnitt kann seitlich in einem Mittelbereich der Konsole oder auch oben auf der Konsole als Quersteg angeordnet sein, um Fachböden oben auf der Konsole zu montieren.

In einer bevorzugten Ausführungsform ist die Konsole ein Stanzteil, das in einem Stück gefertigt ist, wobei der Auflageabschnitt durch Umbiegen aus dem Trägerabschnitt ausgeformt ist und in einem Eingriffabschnitt und dem Trägerabschnitt eine zusammenhängende Öffnung zur Aufnahme des Gehäuses der Stromabnehmereinrichtung ausgestanzt ist. Die Konsole kann aber auch anders, bspw. durch Gießen, Formen, Fügen und dgl. gefertigt sein.

Die Stromabnehmereinrichtung ist in der Aufnahmeöffnung der Konsole derart angeordnet, dass das Gehäuse quer durch diese hindurchragt und zu beiden Seiten der Konsole geringfügig vorsteht. Von einer Seite aus ragen die Abgriffkontakte der Stromabnehmereinrichtung nach außen vor.

Die Abgriffkontakte sind vorzugsweise durch in dem Gehäuse federnd gelagerte Stromabnehmer, bevorzugterweise in Form von Drähten, gebildet, die mit einem Endabschnitt in dem Verbindungsabschnitt der Stromabnehmereinrichtung festgespannt, unter Bildung mehrfacher Biegungen zu dem Stromabnahmeabschnitt geführt und an dem Stromabnahmeabschnitt hakenförmig herausgeführt sind, um die Abgriffkontakte zu bilden. Die federnde Lagerung kann insbesondere durch eine Eigenelastizität der elastisch biegbaren Drähte gegeben sein. Bevorzugterweise werden runde Drähte für die Stromabnehmer verwendet, wobei jedoch auch flache Drähte, Kontaktzungen oder dgl., verwendet werden können. Prinzipiell wäre es auch möglich, nicht elastisch biegbare Kontakte zu verwenden und diese durch geeignete Federelemente nach außen vorzuspannen.

Die Hakenform der Stromabnehmer an der Stelle der herausgeführten Abgriffkontakte ist geeignet, z.B. U-, C- oder V-förmig gestaltet, damit beim Einführen des Eingriffsabschnitts der Konsole in eine Lochung die Abgriffkontakte durch die die Lochung begrenzende Seitenwandung quer belastet und zu dem Gehäuse hin soweit elastisch abgelenkt werden, dass sie die Seitenwandung der Lochung passieren können, wobei die Abgriffkontakte dann in dem Innenraum wieder elastisch herausfedern und mit den zugehörigen Stromleitern in Kontakt gelangen. Ebenso erleichtert die Hakenform der Abgriffkontakte ein Heraushängen der Konsole durch Eindrücken der Abgriffkontakte in das Gehäuse in Wechselwirkung mit der Seitenwandung der Lochung.

Das Gehäuse der erfindungsgemäßen Stromabnehmereinrichtung ist vorzugsweise konzipiert, um die Stromabnehmer bis auf die Abgriffkontakte vollständig einzuschließen und gegen Berührung zu schützen. In einer bevorzugten Ausführungsform gehören zu dem Gehäuse ein Grundteil, das den Verbindungsabschnitt und den Stromabnahmeabschnitt umfasst und Aussparungen zur Aufnahme der Stromabnehmer, z.B. Runddrähte, aufweist, und ein Deckelteil, das eingerichtet ist, um an dem Grundteil befestigt zu werden. Das Gehäuse kann vorzugsweise aus Kunststoff spritzgegossen sein. Jedenfalls ist es aus einem elektrisch isolierenden Material gefertigt.

Der Stromabnahmeabschnitt kann wie der zugehörige Eingriffsabschnitt der Konsole eine Höhe aufweisen, die gegenüber der Höhe der Lochung reduziert ist, um ein Spiel in der Lochung bereitzustellen, das ein Einhängen der Konsole erleichtert. Die Breite des Stromabnahmeabschnitts ist vorzugsweise an die Breite des zugehörigen Eingriffsabschnitts und der Lochung angepasst, um spielarm durch die Lochung zu passen. Die Breite des Stromabnahmeabschnitts und des Eingriffsabschnitts können aber auch nur einen Bruchteil der der Lochung betragen.

In einer vorteilhaften Weiterbildung weist das Grundteil im Bereich des Verbindungsabschnitts auf einer Breitseite eine vorzugsweise einstückig ausgebildete geschlossene Grundplatte auf, die das Grundteil von außen unzugänglich verschließt, während das Grundteil auf der anderen Breitseite von dem Deckelteil nach außen verschlossen wird. Über das lösbare Deckelteil kann jederzeit Zugang zum Inneren des Gehäuses geschaffen werden, um bspw. die Anschlusskabel einer Beleuchtungseinrichtung an die Stromabnehmer anzulöten oder anzuschließen.

Das Deckelteil ist vorzugsweise nur im Bereich des Verbindungsabschnitts angeordnet, um den Stromabnahmeabschnitt hinreichend dünn auszugestalten, damit er auch in äußerst schmale Schlitzlochungen hineinpasst. Die Dicke des in den Innenraum der Regalschiene hinein reichenden Stromabnahmeabschnitts, die der Dicke des Grundteils entspricht, ist deutlich geringer als die Dicke des an der Konsole außerhalb der Regalschiene angeordneten Verbindungsabschnitts, die gleich der Summe der Dicken des Grundteils, der Grundplatte und des Deckelteils ist. Die Stromabnehmereinrichtung ist für beliebige Regalschienen mit Schlitz- oder sonstigen Lochungen geeignet.

In einer bevorzugten Ausführungsform ist die Dicke der Grundplatte gemessen senkrecht zu den Breitseiten des Verbindungsabschnitts, kleiner als die Dicke des Deckelteils. In anderen Worten, ist der Verbindungsabschnitt in der Richtung senkrecht zu den Breitseiten in Bezug auf eine senkrechte Mittelebene des Grundteils unsymmetrisch gestaltet. Dadurch kann hinreichend Platz zur Unterbringung der Enden der Stromabnehmer und der Anschlussleitungen der Beleuchtungseinrichtung oder dgl. in dem Deckelteil bereitgestellt werden, ohne dass die Stromabnehmereinrichtung eine benachbarte Konsole stört, die bspw. bei einer Regalschiene mit zweireihiger Lochung in eine benachbarte Lochung eingehängt wird.

Das erfindungsgemäße Regalsystem weist ferner ein oder mehrere Trägerelemente auf, die an der wenigstens einen Konsole vorgesehen sind. Als Trägerelemente kommen unterschiedliche Elemente, wie Fachböden, Körbe, Tragarme und dgl., in Frage. Bevorzugt werden Fachbodenelemente an Konsolen verwendet, die ein elektrisches Gerät, insbesondere eine Beleuchtungseinrichtung, tragen, dessen Anschlussleitungen in dem Verbindungsabschnitt der Stromabnehmereinrichtung mit den Abgriffkontakten leitend verbunden sind. Die Beleuchtungseinrichtung oder dgl. wird dann beim Einhängen der mit Abgriffkontakten versehenen Konsole automatisch mit Strom versorgt. Dabei genügt es, wenn das Fachbodenelement lediglich eine einzige Konsole mit integrierter Stromabnehmereinrichtung aufweist. Eine eventuelle zweite und jede weitere Konsole, die alle das gleiche Fachbodenelement stützen, brauchen keine Stromabnehmereinrichtungen aufzuweisen. Ähnlich muss die Stromschiene auch nur in einer einzelnen Regalschiene und nicht in der oder den anderen Regalschienen für das gleiche Fachbodenelement vorhanden sein.

Weitere vorteilhafte Einzelheiten von Ausführungsformen der Erfindung ergeben sich aus den Unteransprüchen, der Zeichnung sowie der zugehörigen Beschreibung. Die Erfindung wird nachstehend anhand einer Zeichnung näher beschrieben, die beispielhafte, keinesfalls beschränkende Ausführungsformen der Erfindung zeigt, wobei gleiche Bezugszeichen in allen Figuren verwendet werden, um gleiche Elemente zu bezeichnen. Es zeigen:
Figur 1 ein Ausführungsbeispiel eines Regalsystems gemäß der Erfindung in stark vereinfachter Perspektivdarstellung;
Figuren 2a, 2b eine Regalschiene mit einer in dieser integrierten Stromschiene zur Verwendung bei dem Regalsystem nach Figur 1 gemäß der vorliegenden Erfindung, in vereinfachter Perspektivdarstellung und im Querschnitt;
Figuren 3a, 3b Konsolen für Fachbodenträger zur Verwendung bei dem Regalsystem nach Figur 1 und 2, in vereinfachter perspektivischer Darstellung;
Figuren 4a, 4b, 4c die Konsole nach Figur 3b zur Aufnahme einer Stromabnehmereinrichtung gemäß der Erfindung in Seitenansicht, in Draufsicht und in einer Detailansicht von der Seite, in vereinfachter Darstellung;
Figuren 5a und 5b eine erfindungsgemäße Stromabnehmereinrichtung zur Verwendung bei dem Regalsystem nach Figur 1 bis 4, in vereinfachten Perspektivdarstellungen mit Blick auf unterschiedliche Seiten,
Figuren 6a, 6b, 6c Komponenten der Stromabnehmereinrichtung nach Figur 5 in Draufsicht, in vereinfachten isolierten Darstellungen;
Figuren 7a, 7b einen Ausschnitt des erfindungsgemäßen Regalsystems mit in eine Regalschiene eingehängter Konsole mit integrierter Stromabnehmereinrichtung gemäß der Erfindung, in vereinfachten perspektivischen Darstellungen, mit Blick auf unterschiedlicher Seiten;
Figuren 8a, 8b einen Ausschnitt des erfindungsgemäßen Regalsystems mit in eine Regalschiene eingehängter Konsole mit integrierter Stromabnehmereinrichtung gemäß der Erfindung, in stark vereinfachten Darstellungen, in Seitenansicht und in Draufsicht von oben;
Figur 9 eine Draufsicht von oben auf eine Konsole mit integrierter Stromabnehmereinrichtung und eine Regalschiene mit einer modifizierten Ausführungsform einer Stromschiene, in vereinfachter Darstellung, in einer Teilansicht und einer Detaildarstellung in vergrößertem Maßstab; und
Figuren 10a und 10b einen Ausschnitt eines erfindungsgemäßen Regalsystems mit in eine Regalschiene eingehängter Konsole mit integrierter Stromabnehmereinrichtung gemäß der Ausführungsform der Figur 9, in vereinfachten perspektivischen Darstellungen, mit Blick auf unterschiedlicher Seiten.

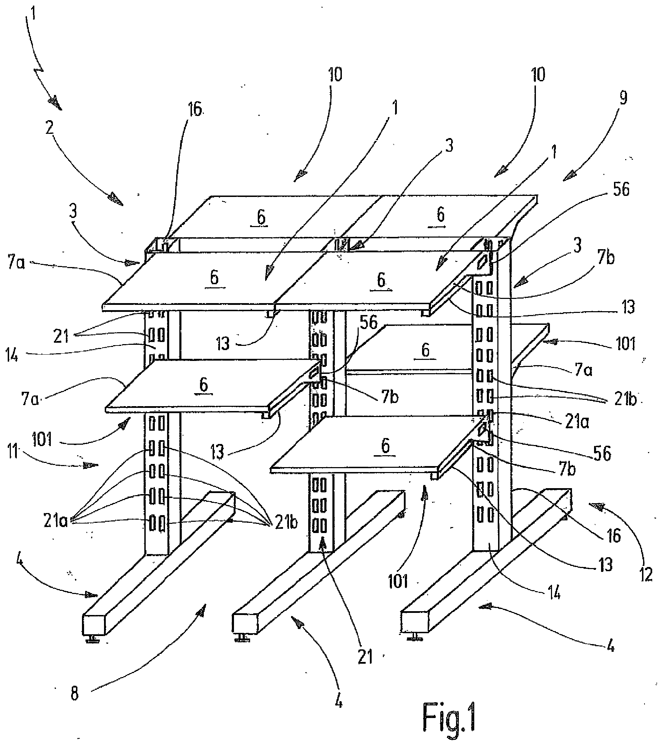

In Figur 1 ist ein insgesamt mit 1 veranschaulichtes Regalsystem in stark vereinfachter perspektivischer Darstellung veranschaulicht. Das Regalsystem 1 ist insbesondere für den Ladenbau zur Warenpräsentation bestimmt. In dem hier dargestellten Ausführungsbeispiel weist das Regalsystem 1 ein Fachbodenregalgestell 2 auf, das hier als ein Kragarmregal zur Aufstellung auf einem Boden eines Aufstellungsraum eingerichtet ist, wobei die vorliegende Erfindung auch auf Wandregale anwendbar ist. Ferner ist verständlich, dass das Regalsystem 1 nicht hinsichtlich der Maße und Erscheinungsform, wie sie aus Figur 1 hervorgehen, beschränkt ist, so dass das Regalsystem 1 z.B. deutlich höher, breiter, tiefer und/oder mit abweichender Erscheinungsform gestaltet sein könnte.

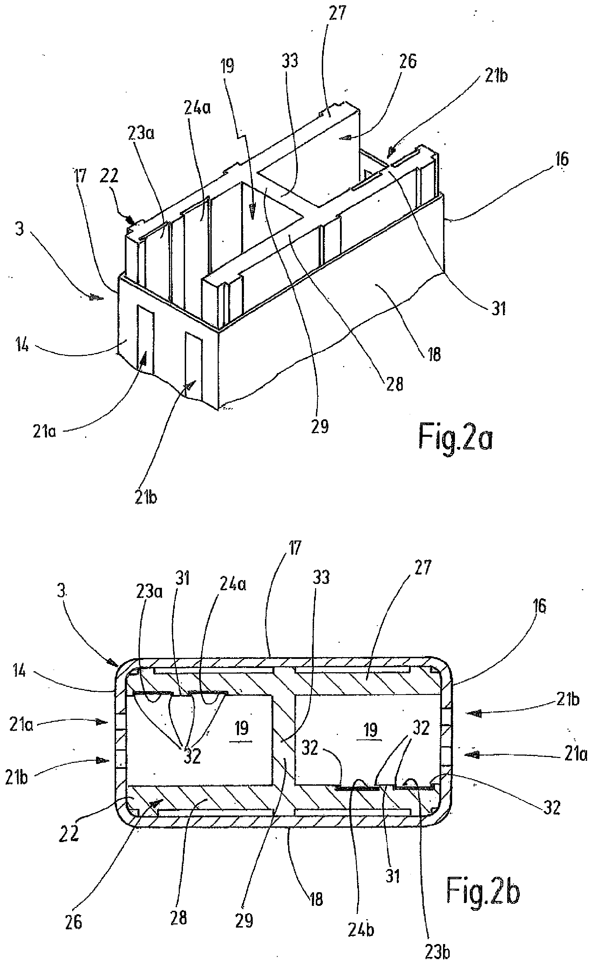

Das Regalsystem 1 weist hier drei Regalschienen 3 auf, die in vertikaler Stellung nebeneinander angeordnet und jeweils an dem in Figur 1 unteren Ende mit horizontalen Schienen 4 verbunden sind, die als Standfüße dienen. Die vertikalen Regalschienen 3 könnten auch anders als in einer Linie nebeneinander angeordnet sein und könnten sich auch direkt auf dem Boden des Aufstellungsraum abstützen, wobei auch weniger oder mehr als drei vertikale Regalschienen 3 vorgesehen sein können. Die Regalschienen 3 könnten im Falle eines Wandregals direkt oder über eine geeignete Aufhängevorrichtung, z.B. eine horizontale Leiste, an einer vertikalen Wand eines Raums angebracht sein. Die Regalschienen 3 sind nachstehend im Zusammenhang mit den Figuren 2a und 2b näher erläutert.

Wie weiter aus Figur 1 hervorgeht, weist das Regalgestell 2 mehrere Fachbodenelemente 6 auf, die über Winkelkonsolen 7 an den Regalschienen 3 höhenverstellbar angeordnet sind. Die Fachbodenelemente 6 sind hier durch plattenförmige Auflageelemente für die zu präsentierende Ware, z.B. Auflageplatten aus Glas, Holz, Metall, Kunststoff oder einem sonstigen Material ausgebildet. Die Fachbodenelemente 6 brauchen aber nicht eben zu sein, und es könnten alternativ oder zusätzlich auch andere Trägerelemente, wie bspw. Körbe, Tragarme oder dgl. an den Regalschienen 3 über die Konsolen 7 befestigt sein. Die Fachbodenelemente 6 sind nur an ihrer einen Langseite über die Winkelkonsolen 7 an den Regalschienen 3 befestigt und ragen auskragend von den Regalschienen 3 vor. Im vorliegenden Fall sind Fachbodenelemente 6 sowohl an der in Figur 1 dem Betrachter zugewandten Vorderseite des Regalgestells 2 als auch an der Hinterseite desselben angebracht.

Zur Erleichterung der Beschreibung kann die dem Betrachter zugewandte Seite des Fachbodenregals 2 als die Vorderseite 8 bezeichnet werden, während die vom Betrachter abgewandte Seite als die Rückseite 9 bezeichnet wird und das Regalsystem 1 ferner eine in Figur 1 von dem Betrachter abgewandte linke Seite 11 und eine zugewandte rechte Seite 12 aufweist. Die Seiten 8 und 9 bzw. 11 und 12 sind dabei jeweils gegeneinander austauschbar, so dass je nach Ausrichtung des Regalsystems 1 auch die Rückseite 9 die Vorderseite 8 bilden könnte.

Wie weiter aus Figur 1 erkennbar, sind an den einzelnen Fachbodenelementen 6 an der in Figur 1 rechten Kurzseite jedes Fachbodenelementes 6 Beleuchtungseinrichtungen 13 angeordnet, die dazu dienen, den darunter befindlichen Raum, insbesondere ein darunter befindliches Fachbodenelement 6 mit darauf präsentierter Ware zu beleuchten. Die Beleuchtungseinrichtungen 13 können bspw. Halogen- oder LED-Leuchten sein und sind nur ein Beispiel für unterschiedliche elektrische Geräte, die bedarfsweise an dem erfindungsgemäßen Regalsystem 1 vorgesehen sein und über in den Regalschienen 3 integrierte Stromschienen mit Energie versorgt werden können. Dies ist in größeren Einzelheiten nachstehend beschrieben.

Wie ferner aus Figur 1 ersichtlich und in den Figuren 2a, 2b näher dargestellt, ist jede Regalschiene 3 hier durch ein Rechteckrohr bzw. -profil gebildet, das (entsprechend den in Figur 1 definierten Richtungen) eine Vorderwand 14, eine Rückwand 16 und zwei Seitenwände 17, 18 aufweist. Die Wände 14, 16, 17, 18 definieren einen inneren Hohlraum 19 der Regalschiene 3, der einen im Wesentlichen rechteckigen Querschnitt aufweist.

Jede Regalschiene 3 weist mehrere Lochungen 21 auf, die durch die Vorderwand 14 hindurchführen, um Zugang zu dem Innenraum 19 der Regalschiene 3 zu schaffen. In dieser Ausführungsform sind zwei Reihen von Lochungen 21a, 21b vorgesehen, die in der dargestellten vertikalen Einsatzlage der Regalschienen 3 im geringen Abstand nebeneinander angeordnet sind, wobei jede Reihe mehrere Lochungen 21a bzw. 21b aufweist, die in gleichmäßigem Abstand untereinander angeordnet sind. Die Lochungen 21a, 21b ermöglichen die Anbringung der Fachbodenelemente 6 oder sonstiger Trägerelemente in unterschiedlichen Höhen des Regalsystems 1 über die Winkelkonsolen 7.

Die Lochungen 21 sind hier in Form von Schlitzen ausgebildet, die jeweils eine nur geringe Weite, gemessen in Seitenrichtung, von in etwa 4-5 mm, vorzugsweise maximal eine derartige Weite aufweisen, dass in die Lochung 21 kaum ein Finger zumindest einer erwachsenen Person hineinpasst. Dies ist insofern wichtig, als zumindest einige der Regalschienen 3 mit einer Stromschiene 22 zur Energieversorgung der Beleuchtungseinrichtung 13 oder eines sonstigen elektrischen Gerätes versehen sind. Die Stromschiene 22 ist nachstehend näher erläutert.

In bevorzugten Ausführungsformen weisen die Schlitze 21 jeweils eine Höhe von etwa 20 mm auf und sind mit einem regelmäßigen Abstand von bspw. 30, 40 oder 50 mm zueinander angeordnet. Es versteht sich, dass diese Maßangaben nur beispielhaft sind und je nach Anforderung variieren können.

Die Beleuchtungseinrichtung 13 kann an einer Konsole 7 oder an einem Tragelement 6 angebracht sein. Wie in größeren Einzelheiten nachstehend beschrieben, ist die Beleuchtungseinrichtung 13 über die Konsole 7 an die in dem Innenraum 19 der Regalschiene 3 angeordnete Stromschiene 22 angeschlossen, um über diese mit elektrischer Energie versorgt zu werden.

Im Folgenden wird auf die Figuren 2 bis 6 Bezug genommen, um die erwähnten Komponenten des erfindungsgemäßen Regalsystems 1 näher zu beschreiben, wobei gleiche Teile jeweils die gleichen Bezugszeichen tragen. Die Zeichnungen sind zum Teil stark schematisiert und in unterschiedlichen Maßstäben dargestellt, um einzelne Details hervorzuheben. Es können auch einzelne Merkmale in einzelnen Zeichnungen weggelassen sein, um einen Blick auf andere Merkmale nicht zu verdecken.

In den Figuren 2a und 2b ist eine Ausführungsform der erfindungsgemäßen Regalschiene 3 mit der darin integrierten Stromschiene 22 dargestellt. Die Stromschiene 22 ist hier zur Niedervolt-Energieversorgung, vorzugsweise für Gleichstrom eingerichtet und weist wenigstens einen ersten Stromleiter 23a z.B. für einen ersten Pol und einen zweiten Stromleiter 24a für einen zweiten, anderen Pol der Spannungsversorgung auf, wobei die Stromleiter 23a, 24a zu einem gemeinsamen Stromkreis gehören.

Die Stromschiene 22 weist einen Grundkörper 26 aus einem isolierenden Material auf, in das der erste und der zweite Stromleiter 23a, 24a in Form von Leiterstreifen eingebettet sind. Im vorliegenden Fall ist der Grundkörper 26 H-profilförmig gestaltet und weist zwei zueinander parallele Leisten 27, 28 und einen die Leisten verbindenden Mittelsteg 29 auf. Die Breite und Tiefe des H-Profils, gemessen entlang der Breite des Mittelstegs 29, bzw. entlang der Breite der Leisten 27, 28, entsprechen der Breite und Tiefe des Innenraums 19 der Regalschiene 3, in der die Stromschiene 22 spielarm und unverlierbar gehalten werden kann. Die Stromschiene 22 wird in die Regalschiene 3 durch ein offenes Ende derselben eingeführt.

Der erste und der zweite Stromleiter 23a, 23b sind parallel und im Abstand zueinander an der Leiste 27 angeordnet. Sie sind in das isolierende Material der Leiste 27 derart eingebettet, dass sie durch das isolierende Material 31 voneinander getrennt und durch vorragende Nasen 32 des isolierenden Materials umgriffen werden. Somit sind die zu dem Innenraum 19 hin offenen Flächen der Stromleiter 23a, 24b gegenüber der innersten Oberfläche des isolierenden Materials 31, 32 zurückversetzt, was für einen zusätzlichen Berührungsschutz sorgt.

Die aus der Regalschiene 3 und der darin integrierten Stromschiene 22 gebildete Einheit ist hier in jeder Querschnittsebene bezüglich eines Mittelpunktes 33 des Mittelstegs 29 spiegel- bzw. punktsymmetrisch. Insofern ist auch an der zweiten Leiste 28 der Stromschiene 22 in der Nähe der Lochungen 21a, 21b der Rückwand 16 ein zweites Paar aus einem ersten und einem zweiten Stromleiter 23b, 24b vorgesehen, wobei die Stromleiter 23b, 24b des zweiten Paars mit denjenigen 23a, 24a des ersten Paars identisch ausgebildet und ebenfalls in dem isolierenden Material 31, 32 derart eingebettet sind, dass sie sich parallel und im Abstand zueinander erstrecken und von den Nasen 32 des isolierenden Materials umgriffen sind. Somit braucht beim Aufbau des Regalsystems 1 nicht auf die Ausrichtung der Regalschiene 3 geachtet zu werden, weil die Vorderwand 14 und die Rückwand 16 identisch sind. Die Winkelkonsolen 7 können in der Vorderwand 14 und/oder der Rückwand 16 fixiert werden, und ein Stromabgriff für eine Beleuchtungseinrichtung 13 oder ein sonstiges elektrisches Gerät kann über die jeweiligen Stromleiter 23a, 24a bzw. 23b, 24b erfolgen.

Im Übrigen sind die Regalschienen 3 vorzugsweise aus Stahl, Aluminium oder einem anderen Metall oder einer Metalllegierung hergestellt, während der Grundkörper 26 der Stromschiene 22 bspw. aus einem isolierenden Kunststoffmaterial gefertigt und spritzgegossen sein kann.

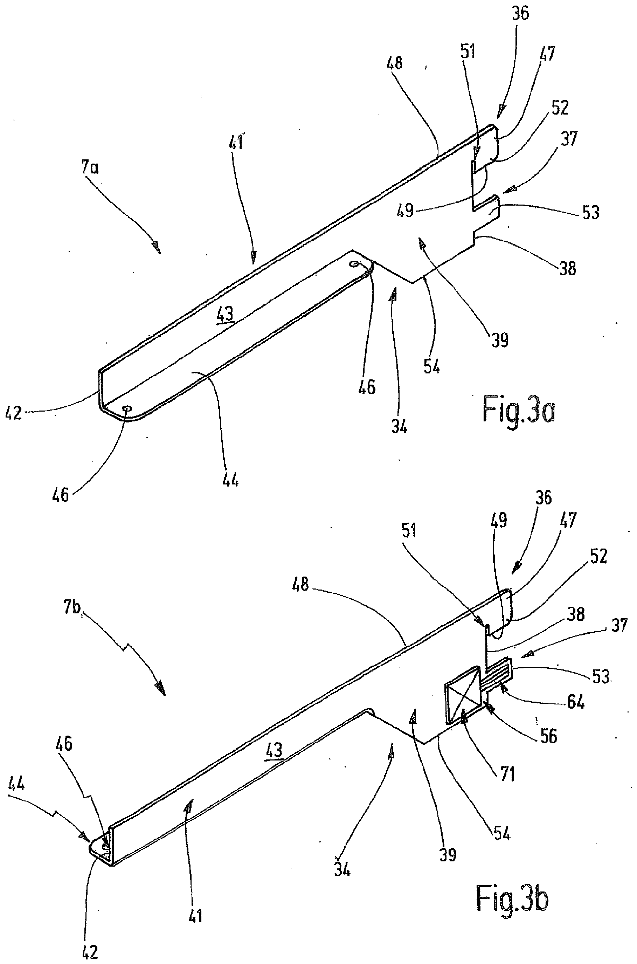

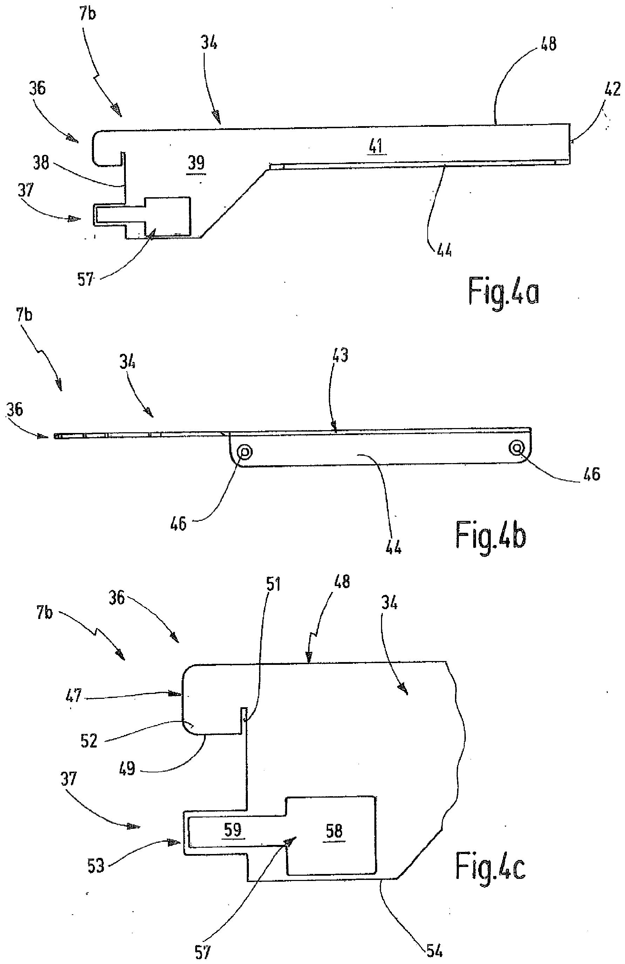

Indem nun auf die Figuren 3 und 4 Bezug genommen wird, zeigen diese bevorzugte Ausführungsformen der erfindungsgemäßen Winkelkonsolen 7, die hier insbesondere zur Aufnahme von plattenförmigen Fachbodenelementen 6 vorgesehen sind. In Figur 3a ist eine linke Konsole 7a und in Figur 3b eine rechte Konsole 7b der Winkelkonsolen 7 aus Figur 1 in vergrößerter perspektivischer Darstellung veranschaulicht. Wie zu ersehen, sind die Winkelkonsolen 7a, 7b im Wesentlichen ähnlich, aber spiegelbildlich zueinander aus einem flachen, plattenartigen Material, vorzugsweise aus Stahlblech, ausgebildet. Vorzugsweise sind sie als Stanzteile in einem Stück im Wesentlichen nur durch Stanzen und Umbiegen gefertigt.

Die in Figur 3a dargestellte erste Konsole 7a weist im Wesentlichen einen Trägerabschnitt 34 sowie einen ersten und einen zweiten Eingriffsabschnitt 36, 37 auf. Der Trägerabschnitt 34 ist hier zum Tragen eines Fachbodenelementes 6 eingerichtet. Der Trägerabschnitt 34 erstreckt sich ausgehend von einer Stützkante 38, die im Einsatz senkrecht angeordnet ist und sich gegebenenfalls an der Vorderwand 14 oder der Rückwand 16 der Regalschiene 3 abstützt, über einen ersten, in Seitenansicht im Wesentlichen trapezförmigen Abschnitt 39 des Trägerabschnitts 34 und einen zweiten Abschnitt 41 desselben, der in Seitenansicht die Form einer langgezogenen rechteckigen Leiste und eine im Vergleich zu dem ersten Abschnitt 39 reduzierte Höhe aufweist, bis zu einem der Stützkante 38 entgegengesetzten freien Ende 42. Der zweite, leistenförmige Abschnitt 41 ist in Bezug auf die ebene Oberfläche 43 des Trägerabschnitts 34, die im Einsatz senkrecht ausgerichtet ist, um 90° umgebogen, um einen zu dem Trägerabschnitt 34 senkrechten Auflageabschnitt zu bilden, der im Einsatz horizontal ausgerichtet ist und zur Montage eines Fachbodenelementes 6 oder sonstigen Trägerelementes dient. Ein Fachbodenelement 6 kann auf den Auflageabschnitt 44 aufgelegt und mittels hier nicht näher dargestellter Befestigungsschrauben durch in dem Auflageabschnitt 44 vorgesehene Befestigungslöcher 46 hindurch auf der Konsole 7a fixiert werden.

Der erste und der zweite Eingriffsabschnitt 36, 37 ragen jeweils von der Stützkante 38 vor und sind dazu vorgesehen, in entsprechende übereinander befindliche Lochungen 21b einzugreifen, um die Konsole 7a an der Regalschiene 3 zu sichern. Der erste Eingriffsabschnitt 36, der hier den oberen Eingriffsabschnitt bildet, ist in Form eines in den Figuren abwärts gerichteten, nasenförmigen Einhängehakens 47 ausgebildet, der an der Stützkante 38 angeformt ist. Der Einhängehaken 47 ist im Wesentlichen durch einen von der Stützkante 38 rückwärts vorragenden, in Seitenansicht rechteckigen Bereich gebildet, der in Höhenrichtung durch eine obere Kante 48, die mit der oberen Kante der Konsole 7a zusammenfällt, und eine untere Kante 49 begrenzt ist, die im Wesentlichen auf Höhe des Auflageabschnitts 44 verläuft und in der ein kleiner Einschnitt 51 eingearbeitet ist, der die Stützkante 38 von einer abwärts gerichteten Hakenspitze 52 des Einhängehakens 47 trennt. Wenn die Konsole 7a an der Regalschiene 3 befestigt ist, umgreift der Einhängehaken 47 eine die zugehörige Lochung 21b begrenzende untere Wandung sattelartig, wobei die Wandung in den Einschnitt 51 einfindet.

Der zweite Eingriffsabschnitt 37 könnte prinzipiell ebenfalls hakenförmig ausgebildet sein. Zur Erleichterung der Handhabung ist er aber in der vorliegenden Ausführungsform in Form eines in Seitenansicht rechteckigen Fortsatzes 53 ausgebildet, der ebenfalls von der Stützkante 38 in rückwärtiger Richtung vorragt. Der Fortsatz 53 ist in einem Abstand, der passend zu dem Abstand der Lochungen 21a, 21b bemessen ist, zu dem Einhängehaken 47 und auch in einem Abstand zu einer unteren Kante 54 des ersten, trapezförmigen Abschnitts 39 des Trägerabschnitts 34 angeordnet. Seine Höhe ist geringer als die des Einhängehakens 47 und die einer Lochung 21a, 21b, um das Einhängen und Aushängen der Konsole 7a in die bzw. aus der Regalschiene 3 zu ermöglichen.

Die Konsole 7b ist im Wesentlichen ähnlich der Konsole 7a mit einem Trägerabschnitt 34, der einen ersten, trapezförmigen Abschnitt 39 und einen zweiten, leistenförmigen Abschnitt 41 aufweist, einem Auflageabschnitt 44 für ein Fachbodenelement, der senkrecht zu dem Trägerabschnitt 34 ausgerichtet ist, einem ersten Eingriffsabschnitt 36 in Form eines Einhängehakens 47 und einem zweiten Eingriffsabschnitt 37 in Form eines im Wesentlichen rechteckigen Fortsatzes 53 ausgebildet. Um Wiederholungen zu vermeiden wird auf die vorstehende Beschreibung dieser Abschnitte und darin enthaltene Merkmale verwiesen.

Im Unterschied zu der ersten Konsole 7a nach Figur 3a ist bei der zweiten Konsole 7b nach Figur 3b der Auflageabschnitt in die entgegengesetzte Richtung von der ebenen Fläche 43 aus umgebogen, damit ein Fachbodenelement, z.B. 6, zwischen den beiden Konsolen 7a, 7b auf den Auflageabschnitten 44 aufgelegt und an diesen gesichert werden kann. Als weiterer Unterschied ist die Konsole 7b hier zur Aufnahme einer in Figur 3b eingezeichneten Stromabnehmereinrichtung 56 eingerichtet. Obwohl die Stromabnehmereinrichtung 56 hier als an der Konsole 7b angebracht veranschaulicht ist, könnte sie alternativ auch an der Konsole 7a nach Figur 3a vorgesehen sein.

Wie aus den Figuren 4a, 4b und 4c hervorgeht, die den Aufbau der Konsole 7b in weiteren Einzelheiten veranschaulichen, weist die Konsole 7b zur Aufnahme der Stromabnehmereinrichtung 56 eine Öffnung 57 auf, die in dem plattenförmigen Material der Konsole 7b, durch diese hindurchführend bspw. durch Ausstanzen erzeugt ist. Die Öffnung 57 weist einen ersten, im Wesentlichen quadratischen Öffnungsabschnitt 58 und einen mit dem ersten Öffnungsabschnitt 58 zusammenhängenden zweiten Öffnungsabschnitt 59 auf, der im Wesentlichen rechteckig ausgebildet ist. Der erste Öffnungsabschnitt ist in dem ersten, trapezförmigen Abschnitt 39 des Trägerabschnitts 34 eingerichtet und in geringem Abstand zu der unteren Kante 54 derselben angeordnet. Der zweite Öffnungsabschnitt 59 erstreckt sich ausgehend von dem ersten Öffnungsabschnitt 58 senkrecht in Richtung auf die Stützkante 38 bis zu dem zweiten Eingriffsabschnitt 37 und weitgehend in diesen hinein. Mit dem zweiten Öffnungsabschnitt 59 weist der zweite Eingriffsabschnitt 37 die Form eines schmalen U-förmigen Rahmens auf.

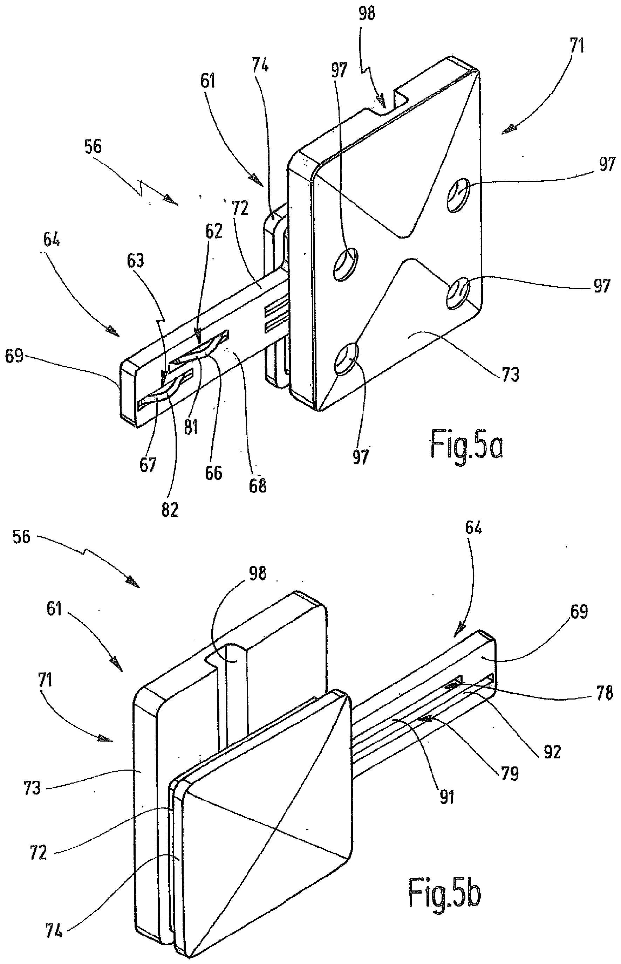

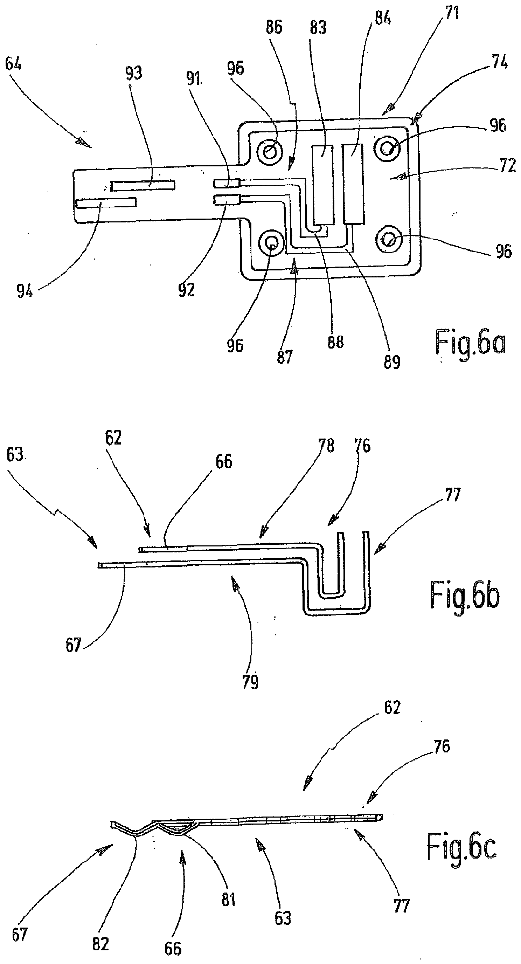

Die Öffnung 57 mit den beiden Abschnitten 58 und 59 ist geeignet gestaltet und bemessen, um die Stromabnehmereinrichtung 56 aufzunehmen. Die Stromabnehmereinrichtung 56 ist in größeren Einzelheiten als zusammengebaute Baugruppe in den Figuren 5a und 5b und mit ihren Einzelkomponenten in den Figuren 6a, 6b und 6c dargestellt.

Figuren 5a und 5b zeigen die erfindungsgemäße Stromabnehmereinrichtung 56 in vereinfachten Perspektivdarstellungen mit Blick auf unterschiedliche Breitseiten derselben. Die Stromabnehmereinrichtung 56 weist allgemein ein Gehäuse 61 auf, in dem Stromabnehmer 62, 63, hier in Form elastischer runder Drähte, angeordnet sind, die zum Stromabgriff an der Stromschiene 22 zur Energieversorgung der Beleuchtungseinrichtung 13 bzw. eines sonstigen an einem Trägerelement befestigten elektrischen Gerätes dienen. Wie in Figur 5a ersichtlich, sind die Stromabnehmer 62, 63 an einem in Figur 5a linken Gehäuseabschnitt, der hier als der Stromabnahmeabschnitt 64 bezeichnet werden soll, herausgeführt, um federnde Abgriffkontakte 66, 67 zur Kontaktierung der Stromleiter 23, 24 der Stromschiene 22 zu bilden.

Der Stromabnahmeabschnitt 64 ist ein rechteckiger Abschnitt des Gehäuses 61, dessen Gestalt und Größe an die Form und Größe des zweiten Öffnungsabschnitts 59 der Öffnung 57 in der Winkelkonsole 7b angepasst ist. Wenn die Stromabnehmereinrichtung 56 an der Konsole 7b angebracht ist, ist der Stromabnahmeabschnitt 64 in dem zweiten Öffnungsabschnitt 59 spielfrei aufgenommen, wobei seine Breitseiten 68, 69 mit den Breitseiten der Konsole 7b im Wesentlichen bündig abschließen.

Das Gehäuse 61 der Stromabnehmereinrichtung 56 weist neben dem Stromabnahmeabschnitt 64 ferner einen Verbindungsabschnitt 71 auf, der im Einsatz an dem Trägerabschnitt 34 der Konsole 7b, insbesondere in dem ersten quadratischen Öffnungsabschnitt 58 der Öffnung 57 angeordnet ist und dazu dient, ein hier nicht näher dargestelltes Anschlusskabel der Beleuchtungseinrichtung 13 oder eines sonstigen elektrischen Gerätes mit den Stromabnehmern 62, 63 zu verbinden.

Das Gehäuse 61 ist hier zweiteilig ausgebildet und weist ein Grundteil 72, das den Verbindungsabschnitt 71 und den Stromabnahmeabschnitt 64 umfasst und Aussparungen zur Aufnahme der Stromabnehmer 62, 63 aufweist, und ein Deckelteil 73, das an dem Grundteil 72 lösbar befestigt ist. Figur 5a zeigt die Stromabnehmereinrichtung 56 mit Blick auf das Deckelteil 73, während Figur 5b die Stromabnehmereinrichtung 56 mit Blick auf eine Rück- bzw. Grundplatte 74 zeigt, die auf der von dem Deckelteil 73 abgewandten Breitseite des Grundteils 72 angeordnet ist und dieses dort nach außen verschließt. Die Grundplatte 74 ist hier und vorzugsweise ein integraler Teil des Grundteils 72. Die Grundplatte 74 weist etwas größere Abmessungen als der Rest des Grundteils 72 auf, so dass, wenn das Grundteil 72 in dem ersten Öffnungsabschnitt 58 in der Konsole 7b angeordnet ist, die Grundplatte 74 die Ränder des ersten Öffnungsabschnitts 58 geringfügig überlappt. Ansonsten ist das Grundteil 72 in Figur 6a näher dargestellt, wobei die Stromabnehmer 62, 62 in den Figuren 6b und 6c näher dargestellt sind.

Wie aus den Figuren 6b und 6c ersichtlich, sind die Stromabnehmer 62 hier durch mehrfach gebogene Drähte 62 gebildet, die hier Runddrähte sind, aber auch durch flache Drähte gebildet sein könnten. Die Drähte 62, 63 sind an einem Ende zu einer U-Form 76, 77 gebogen, wobei der U-förmige Abschnitt 76 des ersten Drahts 63 größer ist als derjenige 77 des zweiten Drahts 64. Die Abschnitte 76, 77 gehen in im Wesentlichen geradlinige Abschnitte 78, 79 über, deren Enden zu U- bzw. V-förmigen Haken 81, 82 umgebogen sind, die die Abgriffkontakte 66, 67 bilden. In dem dargestellten Beispiel ist der geradlinige Abschnitt 78 des ersten Drahts 63 etwas kürzer bemessen als der geradlinige Abschnitt 79 des zweiten Drahts 64, damit die Haken 81, 82 in dem Stromabnahmeabschnitt 64 in einem Abstand nebeneinander angeordnet sind, der dem Abstand der Stromleiter 23, 24 in der Stromschiene 22 entspricht.

Die Drähte 63, 64 sind in dem Grundteil 72 in Aussparungen untergebracht, die an die Form und Größe der Drähte 63, 64 angepasst sind, um diese aufzunehmen und zu führen. Insbesondere weist das Grundteil 72 hierzu zwei größere rechteckige Ausnehmungen 83, 84, die die Enden der U-förmigen Abschnitte 76, 77 der Drähte 63, 64 aufnehmen und die auch die Leitungsenden eines Anschlusskabels der Beleuchtungseinrichtung 13 aufnehmen, um diese, bspw. durch Löten, mit den Enden der Drähte 63, 64 zu verbinden. Es könnten auch Schneidklemmen oder sonstige Mittel in den Ausnehmungen 83, 84 vorgesehen sein, um eine Verbindung der Anschlussleitungen der Beleuchtungseinrichtungen 13 oder eines sonstigen elektrischen Gerätes mit den Stromabnehmern 62, 63 zu erleichtern.

Ausgehend von den Ausnehmungen 83, 84 sind in dem Grundteil 72 Kanäle 86, 87 eingeformt, die an den Verlauf der Drähte 63, 64 angepasst sind, so dass diese in den Kanälen 86, 87 untergebracht werden können. Insbesondere weisen die Kanäle 86, 87 U-förmige Kanalabschnitte 88, 89, die die U-förmigen Abschnitte 76, 77 der Drähte 63, 64 unter Klemmung aufnehmen, sowie geradlinige Abschnitte 91, 92 auf, die sich an die U-förmigen Kanalabschnitte 88, 89 anschließen und entlang des Stromabnahmeabschnitts 64 verlaufen, um die geradlinigen Drahtabschnitte 78 bzw. 79 aufzunehmen. In der Nähe des freien Endes des Stromabnahmeabschnitts 64 sind die geradlinigen Kanalabschnitte 91, 92 in Form von Kanalöffnungen 93, 94 seitlich nach außen herausgeführt, durch die die U- bzw. V-hakenförmigen Abgriffkontakte 66, 67 aus dem Grundteil 72 bzw. Gehäuse 61 heraus über die Breitseite 68 nach außen ragen.

Die Stromabnehmer bzw. Drähte 62, 63 sind bedingt durch ihre Eigenelastizität und ihre Klemmung in dem Verbindungsabschnitt 71 derart federnd gelagert, dass sie bei Belastung durch eine externe Kraft an den Abgriffkontakten 66, 67 gegen die Federkraft in das Grundteil 72 eingedrückt werden können, bis sie vollständig in dem Gehäuse 61 untergebracht sind, wobei sie bei Entlastung durch die Federkraft bzw. Eigenelastizität wieder nach außen, aus dem Grundteil 72 heraus gedrückt werden.

Ferner sind in dem Verbindungsabschnitt 71 des Grundteils 72 Gewindebohrungen 96 vorgesehen, die der Befestigung des Deckelteils 73 an dem Grundteil 72 dienen.

Das Deckelteil 73 ist ein in Draufsicht im Wesentlichen rechteckiger massiver Deckel, der zu den Gewindebohrungen 96 des Grundteils 72 fluchtend ausgerichtete Schulterbohrungen 97 aufweist, die es ermöglichen, den Deckel an der von der Grundplatte 74 angewandten Breitseite des Grundteils 72 mittels Schraubenbolzen zu befestigen, um die Aussparungen 83, 84, 88, 89 zu verschließen und die Drähte 63, 64 in diesen festzuklemmen. Wenn die Stromabnehmereinrichtung 56 in der Öffnung 57 der Konsole 7b eingesetzt und das Deckelteil 73 an dem Grundteil 72 befestigt ist, überlappt der Rand des Deckelteils 73 den Rand der Öffnung 57, der dann zwischen der Grundplatte 74 und dem Deckelteil 73 eingeklemmt ist.

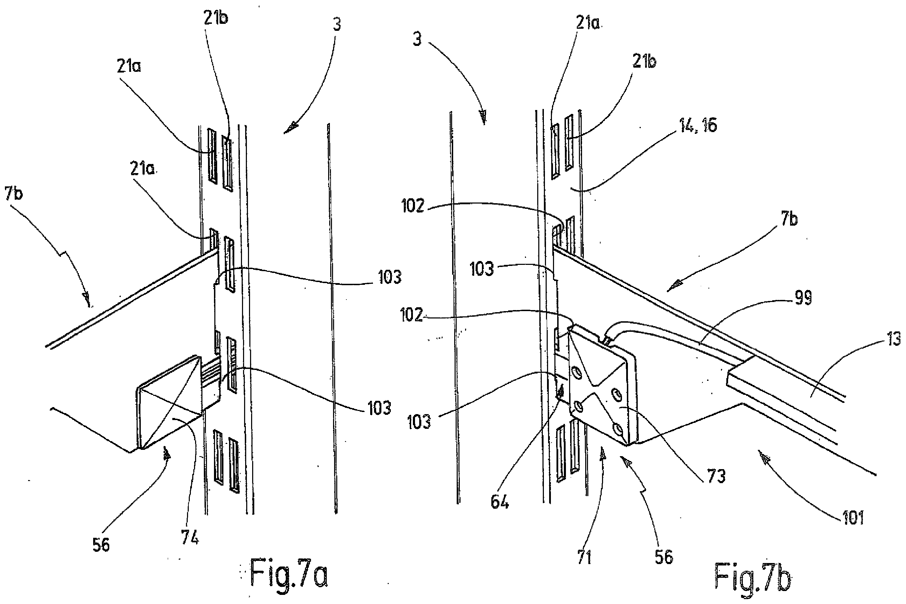

Wie auch aus den Figuren 5a und 5b ersichtlich, weist das Deckelteil 73 einen länglichen Anschlusskanal 98 auf, der, wie aus Figur 7b ersichtlich, ein Anschlusskabel 99 der Beleuchtungseinrichtung 13 oder eines sonstigen elektrischen Gerätes aufnehmen und dessen Leitungen zu den Ausnehmungen 83, 84 zur Verbindung mit den Drähten 63, 64 führen kann. Die Beleuchtungseinrichtung 13 oder ein sonstiges elektrisches Gerät kann an der Konsole 7b oder z.B. an einem Fachbodenelement 6 wahlweise an dessen Kurzseite oder Langseite, je nach Wunsch oder Anforderungen, befestigt sein.

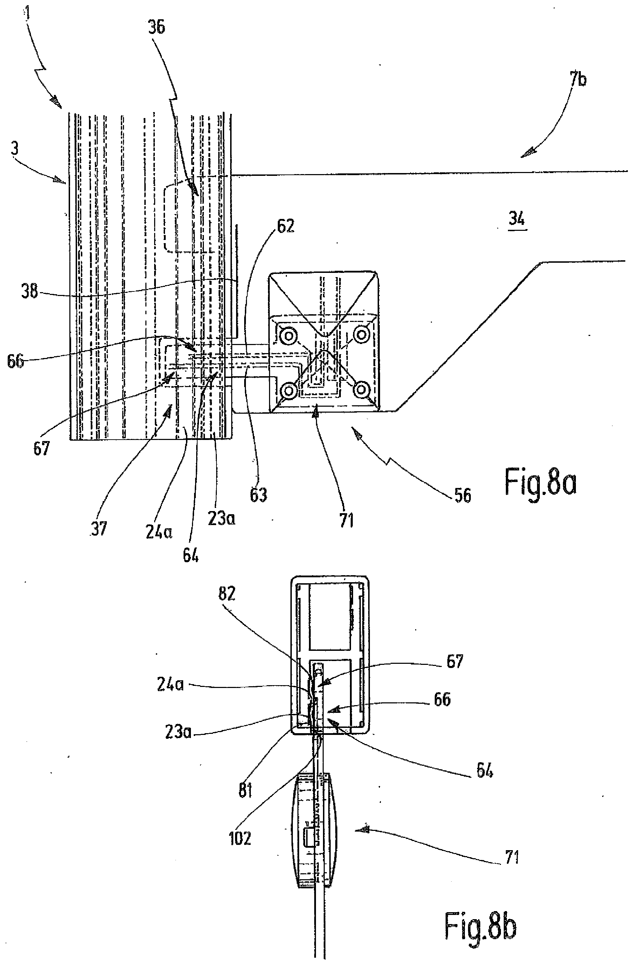

Die Handhabung und Funktionsweise des vorstehend beschriebenen Regalsystems 1 gemäß der veranschaulichten Ausführungsform wird nun unter zusätzlicher Heranziehung der Figuren 7 und 8 erläutert.

Es wird angenommen, dass in die erfindungsgemäßen Regalschienen 3 die Stromschienen 22 bereits in der in den Figuren 2a und 2b dargestellten Weise eingeführt worden sind. Ferner wird angenommen, dass mit den Regalschienen 3 ein Regalgestell 2, ähnlich wie in Figur 1, aufgebaut worden ist, bei dem zwei oder mehrere Regalschienen auf Füßen 4 im Abstand nebeneinander aufgestellt und über geeignete, hier nicht näher veranschaulichte Mittel, wie Querverstrebungen oder dgl., in ihrer relativen Lage zueinander fixiert worden sind. Alternativ können die Regalschienen 3 auch in vertikaler Stellung an einer vertikalen Wand eines Raums befestigt worden sein. Außerdem wird angenommen, dass die Fachbodenelemente 6 bereits an den Auflageabschnitten 44 der zugehörigen Konsolen 7a, 7b befestigt worden sind und an den Winkelkonsolen 7b oder den Fachbodenelemente 6 eine Beleuchtungseinrichtung 13 oder ein anderes elektrischen Gerät montiert ist.

Dann können die so gebildeten Fachbodeneinheiten 101 in die gewünschte Lochungen 21a, 21b zweier benachbarter Regalschienen 6 eingehängt werden. Hierzu werden die Konsolen 7a, 7b einer Fachbodeneinheit 101 im Wesentlichen waagrecht oder leicht schräg von oben in die zugehörigen Lochungen 21b, 21a einer ersten bzw. zweiten Regalschiene 3 eingeführt. Sobald der zweite Abgriffkontakt 67 der Stromabnehmereinrichtung 56 an der Konsole 7b mit der im vorliegenden Beispiel linken Wandung 102, die die Lochung 21a begrenzt, in Eingriff kommt, wird der Abgriffkontakt 67 bedingt durch seine U- bzw. V-förmige Hakengestalt durch die Wandung 102 gegen die aufgrund der Eigenelastizität entgegenwirkende Federkraft in die Kanalöffnung 94 hineingedrückt. Der zweite Abgriffkontakt 67 wird soweit in das Gehäuse 61 eingedrückt, dass er bei weiterem Einschieben der Konsole 7b die Wandung 102 passieren kann, wonach er dann durch die Federkraft aus der Kanalöffnung 94 wieder herausgedrückt wird. Der zweite Abgriffkontakt 67 befindet sich dann in etwa auf Höhe des ersten Stromleiters 23a. Bei weiterem Einschieben der Konsole 7b kommt dann der erste Abgriffkontakt 66 mit der linken Wandung 102 in Eingriff und wird bedingt durch seine U- bzw. V-förmige Hakengestalt durch die Wandung 102 nach innen in die Kanalöffnung 93 soweit eingedrückt, dass bei weiterem Einschieben der Fachbodeneinheit 101 auch der erste Abgriffkontakt 66 die Wandung 102 passieren kann und dann in dem Innenraum 19 durch die Federkraft aus dem Gehäuse 61 herausgedrückt wird. In dieser Stellung, wie sie auch in den Figuren 8a und 8b dargestellt ist, liegen der erste und der zweite Abgriffkontakt 66 bzw. 67 dem ersten bzw. zweiten Stromleiter 23a bzw. 24a (oder auch 23b, 24b) gegenüber und sind hinreichend elastisch gegen diese angedrückt, um einen sicheren Kontakt herzustellen.

Die Konsolen 7a, 7b können anschließend abgesenkt und in die in den Figuren 7a, 7b und 13a dargestellte Endlage gebracht werden, in der der Einhängehaken 47 die in den Figuren untere Begrenzungswand 103 der Lochung 21a, die in den Einschnitt 51 einfindet, sattelartig umgreift und auf dieser aufliegt. Der den zweiten Eingriffsabschnitt 37 bildende Fortsatz 53 liegt ebenfalls auf der unteren Begrenzungswand 103 der zugehörigen Lochung 21a auf, während sich die Stützkante 38 auf der Vorderwand 14 abstützt oder nur wenig von dieser beabstandet ist. Die Beleuchtungseinrichtung 13 kann anschließend eingeschaltet werden und den darüberliegenden oder darunterliegenden Raum des Fachbodenelementes 6 beleuchten. Bei Gleichspannungsversorgung kann die Fachbodeneinheit 101 auch mit bereits eingeschalteter Beleuchtungseinrichtung 13 oder dgl. in der Regalschiene 6 eingehängt werden, wenn der tiefer in dem Innenraum 19 angeordnete zweite Stromleiter 24a, 24b, mit dem der zweite Abgriffkontakt 67 zuletzt in Kontakt gelangt, an den Pluspol der Spannungsversorgung angeschlossen ist. Dann wird durch die erfindungsgemäße Stromabnehmereinrichtung 56 der Stromkreis für die Beleuchtungseinrichtung 13 geschlossen.

Eine Fachbodeneinheit 101 kann ebenso einfach aus- und auf eine andere Höhe umgehängt werden. Hierzu wird die Fachbodeneinheit 101 etwas angehoben, bis die untere Begrenzungswand 103 der Lochung 21a den Einschnitt 51 verlässt und der Einhängehaken 47 mit der Lochung 21a fluchtend angeordnet ist. Dann kann das Fachbodenelement 6 mit den Konsolen 7a, 7b aus den Lochungen 21a, 21b horizontal herausgezogen werden. Bei dieser Herausziehbewegung wird zunächst der elektrische Kontakt zwischen den Abgriffkontakten 66, 67 und den Stromleitern 23a, 24a (bzw. 23b, 24b) automatisch, selbsttätig unterbrochen, wenn diese miteinander außer Eingriff gelangen. Danach kommen nacheinander zunächst der erste 66 und dann der zweite Abgriffkontakt 67 mit der Innenseite der linken Begrenzungswand 102 der Lochung 21a in Eingriff und werden durch diese jeweils gegen die Federkraft elastisch verbogen und in das Gehäuse 61 eingedrückt, wobei sie, wenn sie die linke Begrenzungswand 102 passiert haben, wieder aus dem Gehäuse 61 herausfedern. Der Vorgang des Einhängens der Fachbodeneinheit 101 auf einer anderen Höhe erfolgt in der bereits oben skizzierten Weise.

Die Handhabung des erfindungsgemäßen Regalsystems 1 ist sehr einfach. Das Ein- und Aushängen der Fachbodenelemente oder sonstiger Trägerelemente erfolgt in der gewohnten Weise, wobei gleichzeitig die für die elektrische Versorgung erforderlichen Abgriffkontakte hergestellt bzw. unterbrochen werden. Die erfindungsgemäßen Konsolen 7a, 7b können äußerst schlank und somit passend zu Regalschienen 3 mit sehr schmalen Einhängeschlitzen geschaffen werden. Das Regalsystem 1 weist einfach gestaltete Komponenten auf und lässt sie kostengünstig herstellen.

Eine weitere vorteilhafte Ausgestaltung lässt sich den Figuren 5a, 5b und 13b entnehmen. Wie daraus zu erkennen, ist die Dicke der Grundplatte 74 der Stromabnehmereinrichtung 56 auf der in den Figuren rechten Seite der Konsole 7b, gemessen in der Querrichtung senkrecht zu der Oberfläche 43 der Konsole, geringer als die Dicke des Deckelteils 73. Diese geringe Störkontur der Grundplatte 74 ist insofern vorteilhaft, weil dann eine weitere Konsole 7a einer anderen Fachbodeneinheit 101 in die benachbarte Lochung 21b der zweireihigen Regalschiene 3 problemlos eingesetzt werden kann, ohne dass dies durch die erfindungsgemäße Stromabnehmereinrichtung 56 behindert wird.

Im Rahmen der Erfindung sind zahlreiche Modifikationen möglich. Wie bereits erwähnt, kann die Regalschiene 3 ein- oder zweireihig ausgeführt sein, und die Lochungen 21a, 21b können unterschiedliche Formen, Maße und Abstände zueinander haben. Die Konsolen 7a, 7b können ebenfalls unterschiedlich, einschließlich doppelwandig gestaltet sein. Es können beide Eingriffsabschnitte 36, 37 in Form von Haken ausgebildet sein, die die jeweilige untere Begrenzungswand 103 des Schlitzes 21 hintergreifen. Auch ist es möglich, die Stromabnehmereinrichtung 56 an dem oberen Einhängehaken 47 anzuordnen, wobei die Anordnung an dem unteren zweiten Eingriffsabschnitt 37, insbesondere wenn dieser nicht als Einhängehaken ausgebildet ist, die Handhabung deutlich erleichtert. Wie bereits erwähnt, können mit dem erfindungsgemäßen Regalsystem 1 unterschiedliche freistehende Regalgestelle geschaffen oder ganze Regalwände errichtet werden.

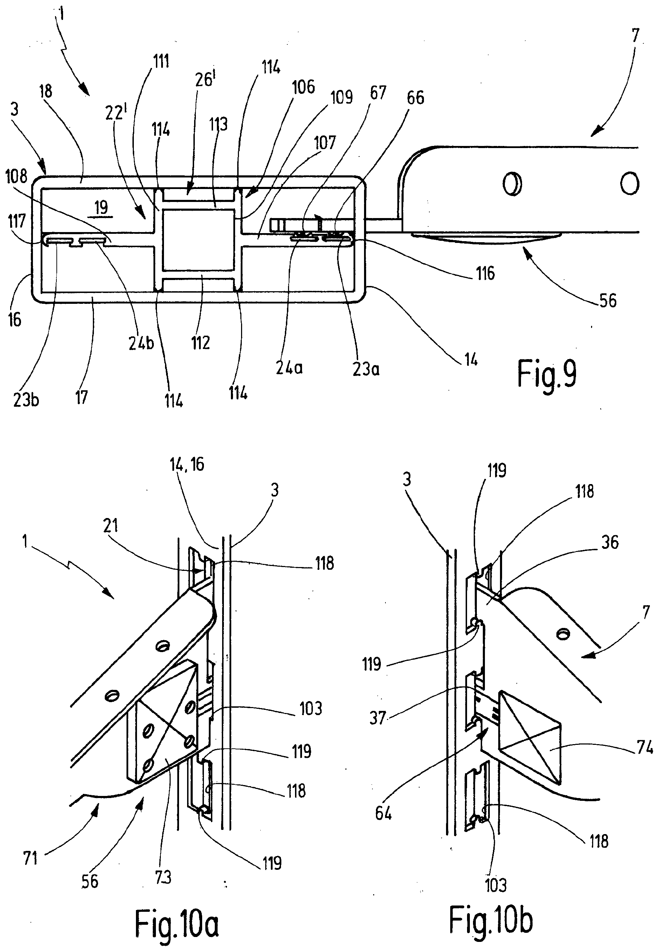

In einer modifizierten Ausführungsform, wie sie in den Figuren 9 dargestellt ist, weist der Grundkörper 26' der Stromschiene 22' einen im Wesentlichen rechteckrohrprofilartigen Mittelkörper 106 auf, der der Befestigung in der Regalschiene 3 dient und die Seiten 109, 111, 112 und 113 aufweist. Der Grundkörper 26' weist ferner wenigstens eine von der Seite 109 des Mittelkörpers 106 aus vorragende Leiste 107 auf, die die zwei oder mehreren zu einem Stromkreis gehörenden Stromleiter 23a, 24a trägt. Der Mittelkörper 106 weist vorzugsweise eine Breite, die an die Breite des Innenraums 19 der Regalschiene 3 angepasst ist, aber eine deutlich geringere Tiefe als der Innenraum 19 auf. Damit ist einerseits ein relativ leichtes Einführen der Stromschiene 22' in die Regalschiene 3 in Längsrichtung derselben zur Montage möglich, während andererseits eine hinreichende Kraftschlussverbindung mit dieser im Einsatz aufrechterhalten werden kann. Wie bei dem H-Profil 22 gemäß den Figuren 2a, 2b können durch geeignete Vorsprünge an dem Grundkörper 26' lediglich schmalflächige oder linienartige Kontaktbereiche 114, 116, 117 zwischen diesem und der Regalschiene 3 vorgesehen sein, die die Handhabung erleichtern. Die Leiste 107 mit den Stromleitern 23a, 24a kann bspw. in etwa in der Mitte der der Vorderwand 14 zugeordneten Seite 109 des Mittelkörpers 106 angeordnet sein und sich nach außen, im montierten Zustand in Richtung auf die Vorderwand 14 erstrecken. Die Stromleiter 23a, 24a sind zumindest auf einer zu der Vorderwand 14 senkrecht ausgerichteten Fläche der Leiste angeordnet. Es können aber auch auf beiden Flächen der Leiste 107, die den Seitenwänden 17, 18 der Regalschiene 3 gegenüberliegen, Stromleiter 23a, 24a für unterschiedliche Stromkreise bzw. Datenübertragungsverbindungen angeordnet sein. Vorzugsweise ist eine weitere entsprechende Leiste 108 mit Stromleitern 23b, 24b an der gegenüberliegenden Seite 111 des Mittelkörpers 106, bevorzugter Weise ebenfalls mittig, ausgebildet und von der Rückwand bzw. Rückseite 16 der Regalschiene 3 aus zugänglich.

Wie aus den Figuren 10a und 10b ersichtlich kann die Regalschiene 3 im Wesentlichen rechteckige Lochungen 21 aufweisen. Es sind zwei kurze Erhebungen 119 vorgesehen, die von der unteren Wandung 103 und der gegenüberliegenden oberen Wandung jeder Lochung 21 aus aufeinander zu verlaufen und die Lochung 21 in etwa in der Mitte ihrer Quererstreckung geringfügig verengen. Ein Eingriffsabschnitt 36, 37 einer Konsole 7 kann in einem Teilabschnitt der Lochung 21 zwischen den Erhebungen 119 und einer Seitenwandung 118 der Lochung 21 aufgenommen werden.

Ein Regalsystem 1, insbesondere zur Warenpräsentation, weist wenigstens eine senkrecht ausgerichtete Regalschiene 3 mit einer Reihe von im Abstand untereinander angeordneten vertikalen Schlitzen 21 auf, die zu einem Innenraum 19 der Regalschiene 3 führen. In dem Innenraum 19 ist eine Stromschiene 22 zur Energieversorgung angeordnet, die einen ersten und einen zweiten Stromleiter 23, 24 aufweist, die entlang einer der Seitenwände 17, 18 der Regalschiene 3 im Abstand nebeneinander verlaufen und voneinander isoliert sind. Ein Trägerelement, bspw. ein Fachbodenelement 6, ist an einer Konsole 7 montiert, die zum Einhängen in die Schlitze 21 der Regalschiene 3 eingerichtet ist, wobei an dem Trägerelement 6 oder der Konsole 7 eine Beleuchtungseinrichtung 13 angebracht ist. Die Konsole 7 weist wenigstens einen Eingriffsabschnitt 37 zum Eingreifen in einen der Schlitze 21 auf. Ferner ist an der Konsole 7 eine Stromabnehmereinrichtung 56 befestigt, die aus einem Gehäuse 61 herausragende Abgriffkontakte 66, 67 aufweist, die an dem Eingriffsabschnitt 37 der Konsole 7 angeordnet sind. Die Abgriffkontakte 66, 67 sind derart federnd eingerichtet und angeordnet, dass sie beim Einhängen der Konsole 7 in die Regalschiene 3 gegen die Federkraft in das Gehäuse 61 elastisch eingedrückt werden können und, sobald sie sich in dem Innenraum 19 der Regalschiene 3 befinden, durch die Federkraft aus dem Gehäuse 61 heraus und gegen die zugehörigen Stromleiter 23, 24 der Stromschiene 22 gedrückt werden, um eine elektrisch leitende Verbindung für die Beleuchtungseinrichtung 13 zu schaffen.

## Patentansprüche

1. Regalsystem, insbesondere zur Warenpräsentation,
mit wenigstens einer Regalschiene (3), die im Einsatz mit ihrer Längserstreckung senkrecht auszurichten ist und wenigstens eine Vorderwand (14) und zwei Seitenwände (17, 18) aufweist, die einen Innenraum (19) der Regalschiene (3) begrenzen, wobei die Vorderwand (14) eine oder mehrere Reihen von Lochungen (21) zur Montage von Trägerelementen (6) in unterschiedlicher Höhe aufweist, wobei die Lochungen (21) längs der Regalschiene (3) im Abstand zueinander angeordnet sind und einen Zugang zu dem Innenraum (19) schaffen,
mit einer in dem Innenraum (19) der Regalschiene (3) integrierten Stromschiene (22, 22') zur Energieversorgung, die wenigstens abschnittsweise entlang der Regalschiene (3) verläuft und einen ersten und einen zweiten Stromleiter (23, 24) aufweist, die entlang einer der Seitenwände (17, 18) der Regalschiene (3) im Abstand nebeneinander verlaufen und voneinander isoliert sind;
mit wenigstens einer Konsole (7), die zum lösbaren Einhängen in eine der Lochungen (21) der Regalschiene (3) eingerichtet ist, wobei die Konsole (7) wenigstens einen Eingriffsabschnitt(36, 37), der eingerichtet und angeordnet ist, um zum Einhängen der Konsole (7) von außen durch eine der Lochungen (21) in der Vorderwand (14) hindurch in den Innenraum (19) der Regalschiene (3) eingeführt zu werden, um im eingehängten Zustand in dem Innenraum (19) angeordnet zu sein, und einen Trägerabschnitt (34) für ein Trägerelement (6) aufweist, der im eingehängten Zustand aus der Regalschiene (3) herausragt, und
mit einer an der Konsole (7) befestigten Stromabnehmereinrichtung (56), die ein Gehäuse (61) mit einem Stromabnahmeabschnitt (64), der an dem Eingriffsabschnitt (36, 37) der Konsole (7) angeordnet ist und aus dem Gehäuse (61) herausragende Abgriffkontakte (66, 67) zur Kontaktierung der Stromleiter (23, 24) der Stromschiene (22) aufweist, und einem Verbindungsabschnitt (71) aufweist, der an dem Trägerabschnitt (34) der Konsole (7) angeordnet ist und zur Verbindung der Abgriffkontakte (66, 67) mit einem Anschlusskabel (99) eines elektrischen Gerätes (13) dient,
wobei die Abgriffkontakte (66, 67) federnd eingerichtet und angeordnet sind, um beim Einhängen der Konsole (7) in die Regalschiene (3) gegen die Federkraft in das Gehäuse (61) eingedrückt zu werden und nach Passieren einer der Lochungen (21) in dem Innenraum (19) hinter der Vorderwand (14) durch die Federkraft aus dem Gehäuse (61) heraus und gegen den ersten bzw. zweiten Stromleiter (23, 24) gedrückt zu werden, um eine elektrisch leitende Verbindung mit diesen herzustellen.

2. Regalsystem nach Anspruch 1, **dadurch gekennzeichnet, dass** die Regalschiene (3) durch ein Rechteckprofil vorzugsweise aus einem metallischen Werkstoff, insbesondere aus Stahl, gebildet ist und ferner eine Rückwand (16) aufweist, die parallel und im Abstand zu der Vorderwand (14) verläuft und eine oder mehrere Reihen von Lochungen (21) zur Montage von Trägerelementen (6) in unterschiedlicher Höhe aufweist, wobei die Lochungen (21) längs der Regalschiene (3) im Abstand zueinander angeordnet sind und einen Zugang zu dem Innenraum (19) schaffen, wobei die Regalschiene (3) vorzugsweise symmetrisch bezüglich senkrecht durch die Vorderwand (14) und senkrecht durch die Seitenwände (17, 18) verlaufender Mittelebenen ausgebildet ist.

3. Regalsystem nach einem der vorhergehenden Ansprüche, **dadurch gekennzeichnet, dass** die Lochungen (21) in Form von äquidistanten Schlitzen (21a, 21b) ausgebildet sind, die durch die jeweilige Wand (14, 16) der Regalschiene (3) hindurchführen, in deren Längsrichtung ausgerichtet sind und eine Weite aufweisen, die ein Eingreifen wenigstens einer Hand einer erwachsenen Person, vorzugsweise auch einer Kinderhand, in den Schlitz (21a, 21b) verhindert.

4. Regalsystem nach einem der vorhergehenden Ansprüche, **dadurch gekennzeichnet, dass** die Stromschiene (22, 22') zur Niedervolt-Energieversorgung, vorzugsweise für Gleichstrom, eingerichtet ist und wenigstens einen ersten Stromleiter (23a; 23b) einer ersten Polung und einen zweiten Stromleiter (24a; 24b) einerzweiten, unterschiedlichen Polung aufweist, die zu einem gemeinsamen Stromkreis gehören.

5. Regalsystem nach einem der vorhergehenden Ansprüche, **dadurch gekennzeichnet, dass** die Stromschiene (22, 22') einen Grundkörper (26, 26') aus einem isolierenden Material aufweist, der wenigstens eine einer Seitenwand (17, 18) der Regalschiene (3) zugeordnete Leiste (27, 28; 107, 108) aufweist, in der ein erster und zweiter Stromleiter (23, 24), vorzugsweise in Form von Leiterstreifen, sich parallel und im Abstand zueinander erstrecken und derart eingebettet sind, dasssiejeweils von dem isolierenden Material (31, 32) umgriffen sind.

6. Regalsystem nach Anspruch 5, **dadurch gekennzeichnet, dass** der Grundkörper (26) durch ein H-Profil gebildet ist, dessen Breite und Tiefe an die Breite und Tiefe des Innenraums (19) der Regalschiene (3) angepasst sind und das zwei zueinander parallele Leisten (27, 28) und einen die Leisten verbindenden Mittelsteg (29) aufweist, wobei ein erstes Paar aus einem ersten und zweiten Stromleiter (23a, 24a) an einer der Leisten (27) und ein zweites Paar aus einem ersten und zweiten Stromleiter (23b, 24b) an der anderen Leiste (28) in Bezug auf einen Mittelpunkt des Mittelstegs (29) spiegelsymmetrisch angeordnet sind.

7. Regalsystem nach Anspruch 5, **dadurch gekennzeichnet, dass** der Grundkörper (26') einen im Wesentlichen rechteckrohrprofilartigen Mittelkörper (106), der der Befestigung in der Regalschiene (3) dient, und eine von einer der Vorderwand (14) zugeordneten Seite des Mittelkörpers (109) aus, vorzugsweise in etwa mittig vorragende Leiste (107) aufweist, die die Stromleiter (23a, 24a) trägt, wobei eine weitere Leiste (108) mit Stromleitern (23b, 24b) auf der gegenüberliegenden Seite (111) des Mittelkörpers (106) vorgesehen ist.

8. Regalsystem nach einem der vorhergehenden Ansprüche, **dadurch gekennzeichnet, dass** die Konsole (7) als eine Winkelkonsole aus einem flachen, plattenartigen Material, vorzugsweise aus Stahlblech, gefertigt ist und einen flachen Trägerabschnitt (34), der sich im Einsatz mit einer Stützkante (38) an der Vorderwand (14) der Regalschiene (3) abstützen kann, sowie wenigstens einen Eingriffsabschnitt (36) in Form eines Einhängehakens (47) aufweist, der an der Stützkante (38) vorragt und eingerichtet ist, um eine die zugehörige Lochung (21) begrenzende Wandung sattelartig zu umgreifen.

9. Regalsystem nach Anspruch 8, **dadurch gekennzeichnet, dass** der Stromabnahmeabschnitt (64) der Stromabnehmereinrichtung (56) in dem Einhängehaken (47) angeordnet ist.

10. Regalsystem nach Anspruch 8, **dadurch gekennzeichnet, dass** die Konsole (7) einen ersten Eingriffsabschnitt (36) in Form eines Einhängehakens (47) und einen weiteren Eingriffsabschnitt (37) aufweist, der im Abstand zu dem ersten Eingriffsabschnitt (36) von der Stützkante (38) vorragt und in dem der Stromabnahmeabschnitt (64) der Stromabnehmereinrichtung (56) angeordnet ist.

11. Regalsystem nach einem der vorhergehenden Ansprüche, **dadurch gekennzeichnet, dass** die Konsole (7)einen senkrecht zu dem Trägerabschnitt (34) ausgerichteten Auflageabschnitt (44) aufweist, der zur Montage eines Fachbodenelementes (6) vorgesehen ist, wobei vorzugsweise die Konsole (7) ein Stanzteil ist, das in einem Stück gefertigt ist, und der Auflageabschnitt (44) durch Umbiegen aus dem Trägerabschnitt (34) ausgeformt ist und in einem Eingriffsabschnitt (36, 37) und dem Trägerabschnitt (34) eine Öffnung (57) zur Aufnahme des Gehäuses (61) der Stromabnehmereinrichtung (56) ausgestanzt ist.

12. Regalsystem nach einem der vorhergehenden Ansprüche, **dadurch gekennzeichnet, dass** die Abgriffkontakte (66, 67) der Stromabnehmereinrichtung (56) an in dem Gehäuse (61) federnd gelagerten Stromabnehmern (62, 63), vorzugsweise in Form von Runddrähten, vorgesehen sind, die in dem Verbindungsabschnitt (71) festgespannt, zu dem Stromabnahmeabschnitt (64) geführt und an dem Stromabnahmeabschnitt (64) hakenförmig herausgeführt sind, um die Abgriffkontakte (66, 67) zu bilden.

13. Regalsystem nach Anspruch 12, **dadurch gekennzeichnet, dass** zu dem Gehäuse (61) der Stromabnehmereinrichtung (56) ein Grundteil (72), das den Verbindungsabschnitt (71) und den Stromabnahmeabschnitt (64) umfasst und Aussparungen (83-92) zur Aufnahme der Stromabnehmer (62, 63) aufweist, und ein Decketeil (73) gehören, das eingerichtet ist, um an dem Grundteil (72) lösbar befestigt zu werden und ein Anschlusskabel (9) des elektrischen Gerätes (13) von außen zu dem Inneren des Grundteils (72) zu führen.

14. Regalsystem nach Anspruch 13, **dadurch gekennzeichnet, dass** das Grundteil (72) im Bereich des Verbindungsabschnitts (71) auf einer Breitseite eine vorzugsweise einstückig mit diesem ausgebildete geschlossene Grundplatte (74) aufweist und auf der anderen Breitseite von dem Deckelteil (73) von au-ßen unzugänglich verschlossen ist, wobei die Dicke der Grundplatte (74), gemessen senkrecht zu den Breitseiten, vorzugsweise kleiner ist als die Dicke des Deckelteils (73).

15. Regalsystem nach einem der vorhergehenden Ansprüche, das ferner wenigstens ein Fachbodenelement (6) aufweist, das an der wenigstens einen Konsole (7a, 7b) befestigt ist, wobei das Fachbodenelement (6) oder die Konsole (7a, 7b) ein elektrisches Gerät, insbesondere eine Beleuchtungseinrichtung (13), trägt, dessen Anschlusskabel (99) in dem Verbindungsabschnitt (71) der Stromabnehmereinrichtung (56) mit den Stromabnehmern (62, 63) elektrisch verbunden ist, wobei das Fachbodenelement (6) vorzugsweise einerseits an einer ersten Konsole (7b), die die Stromabnehmereinrichtung (56) aufweist, und andererseits an einer zweiten Konsole (7a), die keine Stromabnehmereinrichtung aufweist, befestigt ist und die Stromabnehmereinrichtung (56) die erforderliche elektrische Anbindung des elektrischen Gerätes (13) zum Betrieben desselben sicherstellt.

## Claims

1. Shelving system, in particular for goods presentation,
with at least one shelving bar (3) which in use is oriented with its longitudinal extension vertically and comprises at least one front wall (14) and two side walls (17, 18) which delimit an interior (19) of the shelving bar (3), wherein the front wall (14) has one or more rows of holes (21) for mounting of carrier elements (6) at different heights, wherein the holes (21) are arranged spaced apart from each other along the shelving bar (3) and create access to the interior (19);
with a busbar (22, 22') for power supply which is integrated in the interior (19) of the shelving bar (3) and runs at least in portions along the shelving bar (3) and has a first and a second conductor (23, 24) which run next to each other and spaced apart along one of the side walls (17, 18) of the shelving bar (3) and are isolated from each other;
with at least one bracket (7) which is configured for releasable mounting in one of the holes (21) of the shelving bar (3), wherein the bracket (7) has at least one engagement portion (36, 37) which, for mounting of the bracket (7), is configured and arranged for being introduced into the interior (19) of the shelving bar (3) from the outside through one of the holes (21) in the front wall (14), in order to be arranged in the interior (19) in mounted state, and comprises a carrier portion (34) for a carrier element (6) which in mounted state protrudes out of the shelving bar (3); and
with a current collector device (56) attached to the bracket (7) and having a housing with a current collector portion (64) which is arranged on the engagement portion (36, 37) of the bracket (7) and has tapping contacts (66, 67) protruding from the housing (61) for contacting of the conductors (23, 24) of the busbar (22), and a connecting portion (71) which is arranged on the carrier portion (34) of the bracket (7) and serves to connect the tapping contacts (66, 67) to a connecting cable (99) of an electrical device (13);
wherein the tapping contacts (66, 67) are configured sprung and arranged to be pressed into the housing (61) against the spring force when the bracket (7) is mounted in the shelving bar (3) and, after passing through one of the holes (21) in the interior (19) behind the front wall (14), be pressed by spring force out of the housing (61) and against the first or second conductor (23, 24) in order to create an electrically conductive connection therewith.

2. Shelving system according to claim 1, **characterized in that** the shelving bar (3) is formed from a rectangular profile of preferably a metallic material, in particular steel, and furthermore has a back wall (16) which runs parallel to and spaced from the front wall (14) and has one or more rows of holes (21) for mounting of carrier elements (6) at different heights, wherein the holes (21) are arranged spaced apart from each other along the shelving bar (3) and create access to the interior (19), wherein the shelving bar (3) is formed preferably symmetrical relative to centre planes running perpendicularly through the front wall (14) and perpendicularly through the side walls (17, 18).

3. Shelving system according to one of the preceding claims, **characterized in that** the holes (21) are formed as equidistant slots (21a, 21b) which lead through the respective wall (14, 16) of the shelving bar (3), are oriented in its longitudinal direction and have a width which prevents the introduction of at least a hand of an adult person, preferably also a child's hand, into the slot (21a, 21b).

4. Shelving system according to any of the preceding claims, **characterized in that** the busbar (22, 22') is configured for low-voltage energy supply, preferably for direct current, and has at least a first conductor (23a; 23b) of a first polarity and a second conductor (24a; 24b) of a second different polarity which belong to a common circuit.

5. Shelving system according to any of the preceding claims, **characterized in that** the busbar (22, 22') has a base body (26, 26') of an isolating material having at least one strip (27, 28; 107, 108) which is assigned to a side wall (17, 18) of the shelving bar (3) and in which a first and a second conductor (23, 24), preferably in the form of conductor strips, run parallel to and spaced apart from each other and are embedded such that they are each surrounded by the isolating material (31, 32).

6. Shelving system according to claim 5, **characterized in that** the base body (26) is formed by an H profile, the width and depth of which are adapted to the width and depth of the interior (19) of the shelving bar (3), and which has two mutually parallel strips (27, 28) and a centre web (29) connecting the strips, wherein a first pair of a first and a second conductor (23a, 24a) is arranged on one of the strips (27) and a second pair of a first and a second conductor (23b, 24b) is arranged on the other strip (28) mirror-symmetrically relative to a centre point of the centre web (29).

7. Shelving system according to claim 5, **characterized in that** the base body (26') has a central body (106) formed substantially as a rectangular tube profile which serves for fixing in the shelving bar (3), and has a side of the central body (109) assigned to the front wall (14), preferably a strip (107) protruding approximately centrally which carries the conductors (23a, 24a), wherein a further strip (108) with conductors (23b, 24b) is provided on the opposite side (111) of the central body (106).

8. Shelving system according to any of the preceding claims, **characterized in that** the bracket (7) is made as an angle bracket from a flat plate-like material, preferably sheet steel, and has a flat carrier portion (34) which, in use, can rest with a supporting edge (38) on the front wall (14) of the shelving bar (3), and at least one engagement portion (36) in the form of a mounting hook (47) which protrudes at the supporting edge (38) and is configured to surmount as a saddle a wall delimiting the associated hole (21).

9. Shelving system according to claim 8, **characterized in that** the current collector portion (64) of the current collector device (56) is arranged in the mounting hook (47).

10. Shelving system according to claim 8, **characterized in that** the bracket (7) has a first engagement portion (36) in the form of a mounting hook (47) and a further engagement portion (37) which protrudes from the supporting edge (38) at a distance from the first engagement portion (36) and in which the current collector portion (64) of the current collector device (56) is arranged.

11. Shelving system according to any of the preceding claims, **characterized in that** the bracket (7) has a contact portion (44) oriented perpendicularly to the carrier portion (34) and provided for mounting of a shelf element (6), wherein preferably the bracket (7) is a punched part which is produced integrally, and the contact portion (44) is formed by bending from the carrier portion (34), and an opening (57) is punched out of an engagement portion (36, 37) and of the carrier portion (34) for receiving the housing (61) of the current collector device (56).

12. Shelving system according to any of the preceding claims, **characterized in that** the tapping contacts (66, 67) of the current collector device (56) are provided on current collectors (62, 63) sprung-mounted in the housing (61), preferably in the form of round wires which are firmly clamped in the connecting portion (71), guided to the current collector portion (64) and conducted out of the current collector portion (64) in the manner of hooks in order to form the tapping contacts (66, 67).

13. Shelving system according to claim 12, **characterized in that** the housing (61) of the current collector device (56) includes a base part (72) which comprises the connecting portion (71) and the current collector portion (64) and has recesses (83-92) for receiving the current collectors (62, 63), and a cover part (73) which is configured to be releasably attached to the base part (72) and guide a connecting cable (9) of the electrical device (13) from the outside to the inside of the base part (72).

14. Shelving system according to claim 13, **characterized in that** in the region of the connecting portion (71), on a wide side, the base part (72) has a closed base plate (74) which is preferably configured integrally therewith, and on the other wide side is closed by the cover part (73) to be inaccessible from the outside, wherein the thickness of the base plate (74) measured vertically to the wide sides is preferably less than the thickness of the cover part (73).

15. Shelving system according to any of the preceding claims which furthermore comprises a shelf element (6) attached to at least one bracket (7a, 7b), wherein the shelf element (6) or the bracket (7a, 7b) carries an electrical device, in particular a lighting device (13), the connecting cable (99) of which is electrically connected to the current collectors (62, 63) in the connecting portion (71) of the current collector device (56), wherein the shelf element (6) is preferably attached firstly to a first bracket (7b) having the current collector device (56) and secondly to a second bracket (7a) not having a current collector device, and the current collector device (56) provides the electrical connection of the electrical device (13) necessary for its operation.

## Revendications

1. Système d'étagère, en particulier pour la présentation de marchandises,
comprenant au moins un rail d'étagère (3) qui, lors de l'utilisation, doit être orienté verticalement avec sa dimension longitudinale et présente au moins une paroi avant (14) et deux parois latérales (17, 18) qui délimitent un espace interne (19) du rail d'étagère (3), la paroi avant (14) présentant une ou plusieurs rangées de perforations (21) en vue du montage d'éléments supports (6) à des hauteurs différentes, les perforations (21) étant disposées à distance les unes des autres le long du rail d'étagère (3), et créant un accès à l'espace interne (19),
comprenant une barre conductrice (22, 22') pour l'alimentation en énergie, qui est intégrée dans l'espace interne (19) du rail d'étagère (3) et s'étend au moins par portions le long du rail d'étagère (3) et présente un premier et un deuxième conducteur (23, 24), qui s'étendent à distance l'un à côté de l'autre, le long de l'une des parois latérales (17, 18) du rail d'étagère (3), et sont isolés l'un vis-à-vis de l'autre ;
comprenant au moins une console (7) qui est agencée pour l'accrochage libérable dans l'une des perforations (21) du rail d'étagère (3), la console (7) présentant au moins une portion d'engagement (36, 37) qui, en vue de l'accrochage de la console (7), est agencée et disposée pour être introduite de l'extérieur dans l'espace interne (19) du rail d'étagère (3), à travers l'une des perforations (21) dans la paroi avant (14), afin d'être disposée, à l'état accroché, dans l'espace interne (19), et présentant une portion de support (34) pour un élément support (6), qui, à l'état accroché, dépasse du rail d'étagère (3), et
comprenant un dispositif à balais conducteurs (56) qui est fixé à la console (7) et présente un boîtier (61), doté d'une partie à balais conducteurs (64) qui est disposée sur la portion d'engagement (36, 37) de la console (7) et comporte des contacts de prise (66, 67) destinés à établir le contact avec les conducteurs (23, 24) de la barre conductrice (22), et une partie de liaison (71) qui est disposée sur la portion de support (34) de la console (7) et sert à la liaison des contacts de prise (66, 67) avec un câble de connexion (99) d'un appareil électrique (13),
les contacts de prise (66, 67) étant agencés et disposés de façon élastique pour être enfoncés dans le boîtier (61), à l'encontre de la force élastique, lors de l'accrochage de la console (7) dans le rail d'étagère (3), et, après le passage dans l'une des perforations (21), une fois dans l'espace interne (19), derrière la paroi avant (14), être pressés hors du boîtier (61) par la force élastique et contre le premier ou le deuxième conducteur (23, 24), afin d'établir une liaison électriquement conductrice avec ceux-ci.

2. Système d'étagère selon la revendication 1, **caractérisé en ce que** le rail d'étagère (3) est constitué d'un profilé rectangulaire, de préférence en matériau métallique, notamment en acier, et présente en outre une paroi arrière (16) qui s'étend parallèlement à la paroi avant (14) et à distance de celle-ci et présente une ou plusieurs rangées de perforations (21) en vue du montage d'éléments supports (6) à des hauteurs différentes, les perforations (21) étant disposées à distance les unes des autres le long du rail d'étagère (3), et créant un accès à l'espace interne (19), le rail d'étagère (3) étant de préférence réalisé de façon symétrique par rapport à des plans médians s'étendant perpendiculairement à la paroi avant (14) et perpendiculairement aux parois latérales (17, 18).

3. Système d'étagère selon l'une des revendications précédentes, **caractérisé en ce que** les perforations (21) sont réalisées sous forme de fentes (21a, 21b) équidistantes qui traversent 1a paroi (14, 16) respective du rail d'étagère (3), sont orientées dans le sens longitudinal de celui-ci et présentent une largeur qui empêche l'engagement au moins de la main d'un adulte, de préférence également d'une main d'enfant, dans la fente (21a, 21b).

4. Système d'étagère selon l'une des revendications précédentes, **caractérisé en ce que** la barre conductrice (22, 22') est conçue pour l'alimentation en énergie basse tension, de préférence pour du courant continu, et présente au moins un premier conducteur (23a ; 23b) d'une première polarité et un deuxième conducteur (24a ; 24b) d'une deuxième polarité, différente, qui font partie d'un même circuit électrique.

5. Système d'étagère selon l'une des revendications précédentes, **caractérisé en ce que** la barre conductrice (22, 22') présente un corps de base (26, 26') en matériau isolant comportant au moins une aile (27, 28 ; 107, 108) qui est associée à une paroi latérale (17, 18) du rail d'étagère (3) et dans laquelle un premier et un deuxième conducteur (23, 24) s'étendent de préférence sous forme de bandes conductrices, parallèlement et à distance l'un de l'autre, et sont encastrés de manière à ce qu'ils soient chacun entourés par le matériau isolant (31, 32),

6. Système d'étagère selon la revendication 5, **caractérisé en ce que** le corps de base (26) est constitué d'un profilé en H dont la largeur et la profondeur sont adaptées à la largeur et la profondeur de l'espace interne (19) du rail d'étagère (3) et qui présente deux branches (27, 28) mutuellement parallèles et une barre centrale (29) reliant les branches, une première paire formée d'un premier et d'un deuxième conducteur (23a, 24a) étant disposée sur l'une des branches (27), et une deuxième paire formée d'un premier et d'un deuxième conducteur (23b, 24b) étant disposée sur l'autre branche (28), de façon symétrique par rapport à un point médian de la barre centrale (29).

7. Système d'étagère selon la revendication 5, **caractérisé en ce que** le corps de base (26') présente un corps central (106) sensiblement en forme de profilé à tube rectangulaire, qui sert à la fixation dans le rail d'étagère (3), et une aile (107) qui avance, de préférence de façon médiane, à partir d'un côté du corps central (106) associé à la paroi avant (14) et qui porte les conducteurs (23a, 24a), une deuxième aile (108) avec des conducteurs (23b, 24b) étant prévue sur le côté opposé (111) du corps central (106).

8. Système d'étagère selon l'une des revendications précédentes, **caractérisé en ce que** la console (7) est réalisée sous forme de console à équerre dans un matériau plat en forme de plaque, de préférence de 1a tôle d'acier, et présente une portion de support (34) plate qui, lors de l'utilisation, peut s'appuyer avec un bord d'appui (38) sur 1a paroi avant (14) du rail d'étagère (3), ainsi qu'au moins une portion d'engagement (36) sous forme de crochet de suspension (47) qui fait saillie sur le bord d'appui (38) et est agencée pour entourer à la manière d'un étrier une paroi délimitant la perforation (21) associée.

9. Système d'étagère selon la revendication 8, **caractérisé en ce que** la partie à balais conducteurs (64) du dispositif à balais conducteurs (56) est disposée dans le crochet (47).

10. Système d'étagère selon la revendication 8, **caractérisé en ce que** la console (7) présente une première portion d'engagement (36), sous la forme d'un crochet de suspension (47), et une deuxième portion d'engagement (37) qui avance à partir du bord d'appui (38), à distance de la première portion d'engagement (36), et dans laquelle est disposée la partie à balais conducteurs (64) du dispositif à balais conducteurs (56).

11. Système d'étagère selon l'une des revendications précédentes, **caractérisé en ce que** la console (7) présente une partie d'appui (44) qui est orientée perpendiculairement à la portion de support (34) et est prévue pour le montage d'un élément formant tablette (6), la console (7) étant de préférence une pièce découpée, réalisée d'un seul tenant, et la partie d'appui (44) étant façonnée par pliage à partir de la portion de support (34), et une ouverture (57) étant découpée dans une portion d'engagement (36, 37) et dans la portion de support (34), en vue de la réception du boîtier (61) du dispositif à balais conducteurs (56).

12. Système d'étagère selon l'une des revendications précédentes, **caractérisé en ce que** les contacts de prise (66, 67) du dispositif à balais conducteurs (56) sont prévus sur des balais conducteurs (62, 63) montés de façon élastique dans le boîtier (61), de préférence sous forme de fils de section circulaire qui sont fixés dans la partie de liaison (71), sont amenés à la partie à balais conducteurs (64) et sortent en forme de crochets sur la partie à balais conducteurs (64), pour constituer les contacts de prise (66, 67).

13. Système d'étagère selon la revendication 12, **caractérisé en ce que** le boîtier (61) du dispositif à balais conducteurs (56) comprend un élément de base (72), qui comporte la partie de liaison (71) et la partie à balais conducteurs (64) et présente des évidements (83 à 92) pour la réception des balais conducteurs (62, 63), et un élément formant couvercle (73) qui est conçu pour être fixé de manière amovible à l'élément de base (72) et amener un câble de connexion (9) de l'appareil électrique (13) de l'extérieur vers l'intérieur de l'élément de base (72).

14. Système d'étagère selon la revendication 13, **caractérisé en ce que** l'élément de base (72) présente, dans la région de la partie de liaison (71), sur un grand côté, une plaque de base (74) pleine réalisée de préférence d'une seule pièce avec la partie de liaison, et, sur l'autre grand côté, est fermé par l'élément couvercle (73) de façon à ne pas être accessible de l'extérieur, l'épaisseur de 1a plaque de base (74), mesurée perpendiculairement aux grands côtés, étant de préférence inférieure à l'épaisseur de l'élément couvercle (73).

15. Système d'étagère selon l'une des revendications précédentes, qui présente en outre au moins un élément tablette (6) qui est fixé à la console (7a, 7b), au nombre d'au moins une, l'élément tablette (6) ou la console (7a, 7b) portant un appareil électrique, notamment un dispositif d'éclairage (13), dont le câble de connexion (99) est relié électriquement aux balais conducteurs (62, 63) dans 1a partie de liaison (71) du dispositif à balais conducteurs (56), l'élément tablette (6) étant de préférence fixé sur un côté à une première console (7b), qui présente le dispositif à balais conducteurs (56), et de l'autre côté à une deuxième console (7a) qui ne présente pas de dispositif à balais conducteurs, et le dispositif à balais conducteurs (56) garantissant le raccordement électrique nécessaire de l'appareil électrique (13) pour faire fonctionner celui-ci.
